# EUROPEAN PATENT SPECIFICATION

(11) **EP 2 509 730 B1**
(45) Date of publication and mention of the grant of the patent: **24.04.2019**
(21) Application number: 10836538.8
(22) Date of filing: 07.12.2010
(51) Int. Cl.: B22F 1/02, B22F 3/12, B22F 7/02, B22F 3/16

(54) **COATED METALLIC POWDER AND METHOD OF MAKING THE SAME**
BESCHICHTETES METALLPULVER UND HERSTELLUNGSVERFAHREN DAFÜR
POUDRE MÉTALLIQUE REVÊTUE ET SON PROCÉDÉ DE FABRICATION

(30) Priority: 08.12.2009 US 633686
(43) Date of publication of application: 17.10.2012
(73) Proprietor: Baker Hughes, a GE company, LLC, Houston, TX 77210-4740 (US)
(72) Inventor: XU, Zhiyue, Cypress Texas 77433 (US); AGRAWAL, Gaurav, Aurora Colorado 80016 (US); SALINAS, Bobby, Sugar Land Texas 77498 (US)
(74) Representative: BRP Renaud & Partner mbB Rechtsanwälte Patentanwälte Steuerberater
(86) International application number: PCT/US2010/059265
(87) International publication number: WO 2011/071907

(56) References cited:
- US-A- 3 385 696
- US-A- 4 741 973
- US-A- 5 292 478
- US-A- 5 352 522
- US-A- 5 985 466
- US-A- 6 024 915
- US-A1- 2005 275 143
- US-A1- 2006 045 787
- US-A1- 2008 105 438
- RENLIANG XU ET AL: "Comparison of sizing small particles using different technologies", POWDER TECHNOLOGY, ELSEVIER SEQUOIA, LAUSANNE, CH, vol. 132, no. 2-3, 24 June 2003 (2003-06-24), pages 145-153, XP002711749, ISSN: 0032-5910, DOI: 10.1016/S0032-5910(03)00048-2

## Description

### BACKGROUND

Oil and natural gas wells often utilize wellbore components or tools that, due to their function, are only required to have limited service lives that are considerably less than the service life of the well. After a component or tool service function is complete, it must be removed or disposed of in order to recover the original size of the fluid pathway for use, including hydrocarbon production, CO₂ sequestration, etc. Disposal of components or tools has conventionally been done by milling or drilling the component or tool out of the wellbore, which are generally time consuming and expensive operations.

In order to eliminate the need for milling or drilling operations, the removal of components or tools by dissolution of degradable polylactic polymers using various wellbore fluids has been proposed. However, these polymers generally do not have the mechanical strength, fracture toughness and other mechanical properties necessary to perform the functions of wellbore components or tools over the operating temperature range of the wellbore, therefore, their application has been limited.

Other degradable materials have been proposed including certain degradable metal alloys formed from certain reactive metals in a major portion, such as aluminum, together with other alloy constituents in a minor portion, such as gallium, indium, bismuth, tin and mixtures and combinations thereof, and without excluding certain secondary alloying elements, such as zinc, copper, silver, cadmium, lead, and mixtures and combinations thereof. These materials may be formed by melting powders of the constituents and then solidifying the melt to form the alloy. They may also be formed using powder metallurgy by pressing, compacting, sintering and the like a powder mixture of a reactive metal and other alloy constituent in the amounts mentioned. These materials include many combinations that utilize metals, such as lead, cadmium, and the like that may not be suitable for release into the environment in conjunction with the degradation of the material. Also, their formation may involve various melting phenomena that result in alloy structures that are dictated by the phase equilibria and solidification characteristics of the respective alloy constituents, and that may not result in optimal or desirable alloy microstructures, mechanical properties or dissolution characteristics.

US5352522 discloses a composite material comprising metallic grains coated with a dielectric US6024915 discloses coated metal particles.

Therefore, the development of materials that can be used to form wellbore components and tools having the mechanical properties necessary to perform their intended function and then removed from the wellbore by controlled dissolution using wellbore fluids is very desirable.

### SUMMARY

The invention provides a metallic powder as claims in claim 1, and a method as claimed in claim 10.

### BRIEF DESCRIPTION OF THE DRAWINGS

Referring now to the drawings wherein like elements are numbered alike in the several Figures:
FIG. 1 is a photomicrograph of a powder 10 as disclosed herein that has been embedded in an epoxy specimen mounting material and sectioned;
FIG. 2 is a schematic illustration of an exemplary embodiment of a powder particle 12 as it would appear in an exemplary section view represented by section 2-2 of FIG. 1;
FIG. 3 is a schematic illustration of a second exemplary embodiment of a powder particle 12 as it would appear in a second exemplary section view represented by section 2-2 of FIG. 1;
FIG. 4 is a schematic illustration of a third exemplary embodiment of a powder particle 12 as it would appear in a third exemplary section view represented by section 2-2 of FIG. 1;
FIG. 5 is a schematic illustration of a fourth exemplary embodiment of a powder particle 12 as it would appear in a fourth exemplary section view represented by section 2-2 of FIG. 1;
FIG. 6 is a schematic illustration of a second exemplary embodiment of a powder as disclosed herein having a multi-modal distribution of particle sizes;
FIG. 7 is a schematic illustration of a third exemplary embodiment of a powder as disclosed herein having a multi-modal distribution of particle sizes;
FIG. 8 is a flow chart of an exemplary embodiment of a method of making a powder as disclosed herein;
FIG. 9 is a photomicrograph of an exemplary embodiment of a powder compact as disclosed herein;
FIG. 10 is a schematic of illustration of an exemplary embodiment of the powder compact of FIG. 9 made using a powder having single-layer coated powder particles as it would appear taken along section 10 - 10;
FIG. 11 is a schematic illustration of an exemplary embodiment of a powder compact as disclosed herein having a homogenous multi-modal distribution of particle sizes;
FIG. 12 is a schematic illustration of an exemplary embodiment of a powder compact as disclosed herein having a non-homogeneous, multi-modal distribution of particle sizes;
FIG. 13 is a schematic illustration of an exemplary embodiment of a powder compact as disclosed herein formed from a first powder and a second powder and having a homogenous multi-modal distribution of particle sizes;
FIG. 14 is a schematic illustration of an exemplary embodiment of a powder compact as disclosed herein formed from a first powder and a second powder and having a non-homogeneous multi-modal distribution of particle sizes.
FIG. 15 is a schematic of illustration of another exemplary embodiment of the powder compact of FIG. 9 made using a powder having multilayer coated powder particles as it would appear taken along section 10 - 10;
FIG. 16 is a schematic cross-sectional illustration of an exemplary embodiment of a precursor powder compact;
FIG. 17 is a flow chart of an exemplary embodiment of a method of making a powder compact as disclosed herein;
FIG. 18 is a table that describes the particle core and metallic coating layer configurations for powder particles and powders used to make exemplary embodiments of powder compacts for testing as disclosed herein;
FIG. 19 a plot of the compressive strength of the powder compacts of FIG. 18 both dry and in an aqueous solution comprising 3% KCl;
FIG. 20 is a plot of the rate of corrosion (ROC) of the powder compacts of FIG. 18 in an aqueous solution comprising 3% KCl at 200°F and room temperature;
FIG. 21 is a plot of the ROC of the powder compacts of FIG. 18 in 15% HCl;
FIG. 22 is a schematic illustration of a change in a property of a powder compact as disclosed herein as a function of time and a change in condition of the powder compact environment;
FIG. 23 is an electron photomicrograph of a fracture surface of a powder compact formed from a pure Mg powder;
FIG. 24 is an electron photomicrograph of a fracture surface of an exemplary embodiment of a powder metal compact as described herein; and
FIG. 25 is a plot of compressive strength of a powder compact as a function the amount of a constituent (Al₂O₃) of the cellular nanomatrix.

### DETAILED DESCRIPTION

Lightweight, high-strength metallic materials are disclosed that may be used in a wide variety of applications and application environments, including use in various wellbore environments to make various selectably and controllably disposable or degradable lightweight, high-strength downhole tools or other downhole components, as well as many other applications for use in both durable and disposable or degradable articles. These lightweight, high-strength and selectably and controllably degradable materials include fully-dense, sintered powder compacts formed from coated powder materials that include various lightweight particle cores and core materials having various single layer and multilayer nanoscale coatings. These powder compacts are made from coated metallic powders that include various electrochemically-active (e.g., having relatively higher standard oxidation potentials) lightweight, high-strength particle cores and core materials, such as electrochemically active metals, that are dispersed within a cellular nanomatrix formed from the various nanoscale metallic coating layers of metallic coating materials, and are particularly useful in wellbore applications. These powder compacts provide a unique and advantageous combination of mechanical strength properties, such as compression and shear strength, low density and selectable and controllable corrosion properties, particularly rapid and controlled dissolution in various wellbore fluids. For example, the particle core and coating layers of these powders may be selected to provide sintered powder compacts suitable for use as high strength engineered materials having a compressive strength and shear strength comparable to various other engineered materials, including carbon, stainless and alloy steels, but which also have a low density comparable to various polymers, elastomers, low-density porous ceramics and composite materials. As yet another example, these powders and powder compact materials may be configured to provide a selectable and controllable degradation or disposal in response to a change in an environmental condition, such as a transition from a very low dissolution rate to a very rapid dissolution rate in response to a change in a property or condition of a wellbore proximate an article formed from the compact, including a property change in a wellbore fluid that is in contact with the powder compact. The selectable and controllable degradation or disposal characteristics described also allow the dimensional stability and strength of articles, such as wellbore tools or other components, made from these materials to be maintained until they are no longer needed, at which time a predetermined environmental condition, such as a wellbore condition, including wellbore fluid temperature, pressure or pH value, may be changed to promote their removal by rapid dissolution. These coated powder materials and powder compacts and engineered materials formed from them, as well as methods of making them, are described further below.

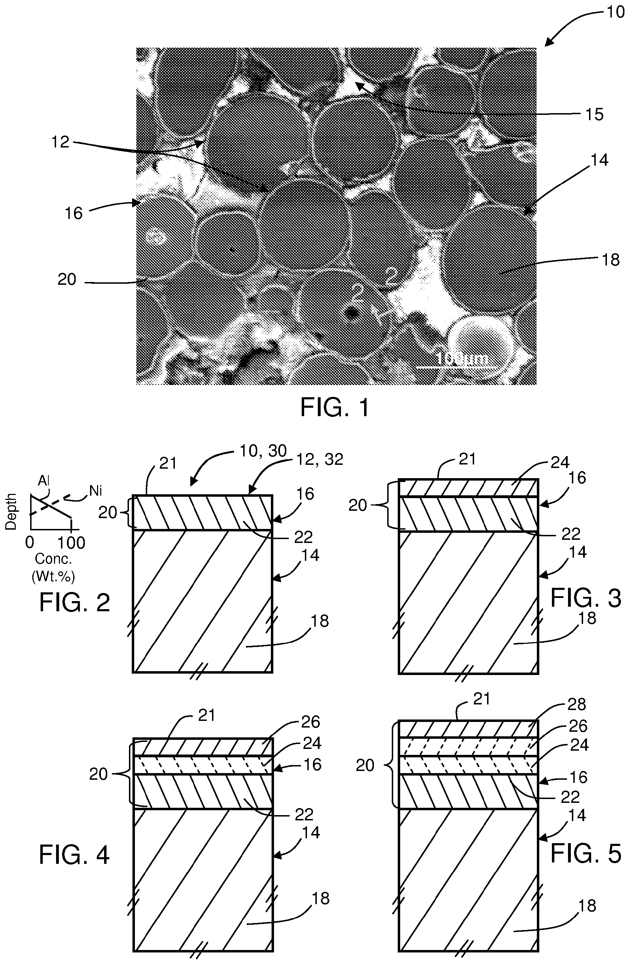

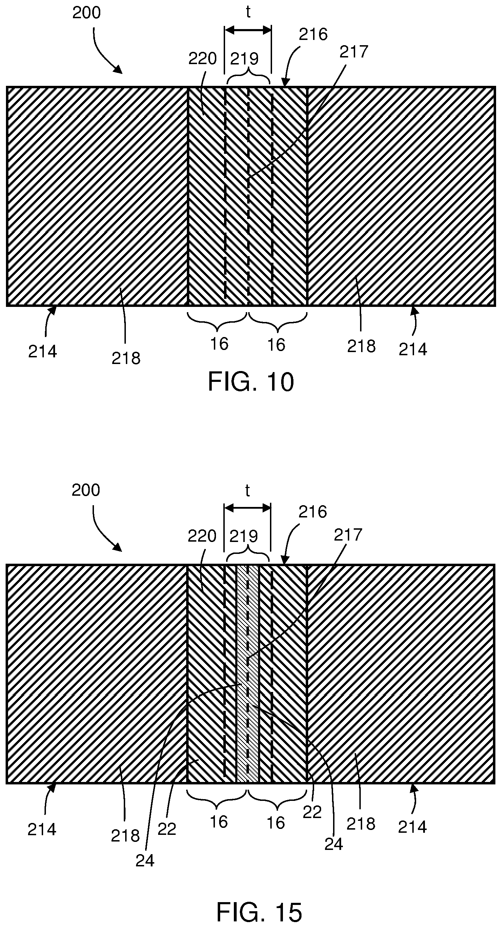

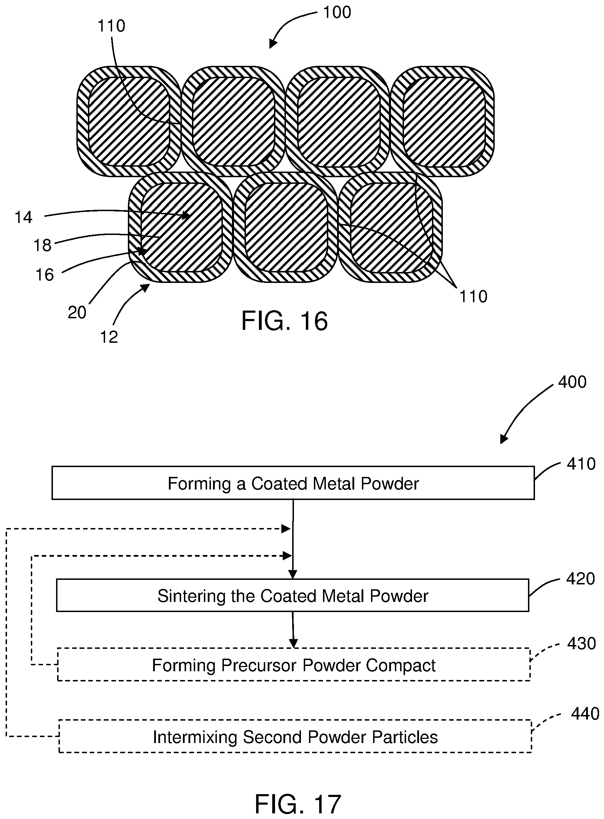

Referring to FIGS. 1-5, a metallic powder 10 includes a plurality of metallic, coated powder particles 12. Powder particles 12 may be formed to provide a powder 10, including free-flowing powder, that may be poured or otherwise disposed in all manner of forms or molds (not shown) having all manner of shapes and sizes and that may be used to fashion precursor powder compacts 100 (FIG. 16) and powder compacts 200 (FIGS. 10-15), as described herein, that may be used as, or for use in manufacturing, various articles of manufacture, including various wellbore tools and components.

Each of the metallic, coated powder particles 12 of powder 10 includes a particle core 14 and a metallic coating layer 16 disposed on the particle core 14. The particle core 14 includes a core material 18. The core material 18 includes a suitable material for forming the particle core 14 that provides powder particle 12 that can be sintered to form a lightweight, high-strength powder compact 200 having selectable and controllable dissolution characteristics. Electrochemically active metals having a standard oxidation potential greater than or equal to that of Zn, including Mg, Al, Mn or Zn or a combination thereof, are very reactive with a number of common wellbore fluids, including any number of ionic fluids or highly polar fluids, such as those that contain various chlorides. Examples include fluids comprising potassium chloride (KCl), hydrochloric acid (HCl), calcium chloride (CaCl₂), calcium bromide (CaBr₂) or zinc bromide (ZnBr₂). Core material 18 may be selected to provide a high dissolution rate in a predetermined wellbore fluid, but may also be selected to provide a relatively low dissolution rate, including zero dissolution, where dissolution of the nanomatrix material causes the particle core 14 to be rapidly undermined and liberated from the particle compact at the interface with the wellbore fluid, such that the effective rate of dissolution of particle compacts made using particle cores 14 of these core materials 18 is high, even though core material 18 itself may have a low dissolution rate, including core materials 20 that may be substantially insoluble in the wellbore fluid.

With regard to the electrochemically active metals as core materials 18, Mg, Al, Mn or Zn may be used as pure metals.

Among the electrochemically active metals, Mg, either as a pure metal or an alloy or a composite material, is particularly useful, because of its low density and ability to form high-strength alloys, as well as its high degree of electrochemical activity, since it has a standard oxidation potential higher than Al, Mn or Zn. Mg alloys that combine other electrochemically active metals, as described herein, as alloy constituents are particularly useful, and are binary Mg-Zn, Mg-Al and Mg-Mn alloys, as well as tertiary Mg-Zn-Y and Mg-Al-X alloys, where X includes Zn, Mn, Si, Ca or Y, or a combination thereof. These Mg-Al-X alloys may include, by weight, up to about 85% Mg, up to about 15% Al and up to about 5% X. Particle core 14 and core material 18, when not pure Mg, Al, Mn or Zn, may also include a rare earth element or combination of rare earth elements. As used herein, rare earth elements include Sc, Y, La, Ce, Pr, Nd or Er, or a combination of rare earth elements. Where present, a rare earth element or combinations of rare earth elements may be present, by weight, in an amount of about 5% or less.

Particle core 14 and core material 18 have a melting temperature (Tp). As used herein, T_{P} includes the lowest temperature at which incipient melting or liquation or other forms of partial melting occur within core material 18, regardless of whether core material 18 comprises a pure metal, an alloy with multiple phases having different melting temperatures or a composite of materials having different melting temperatures.

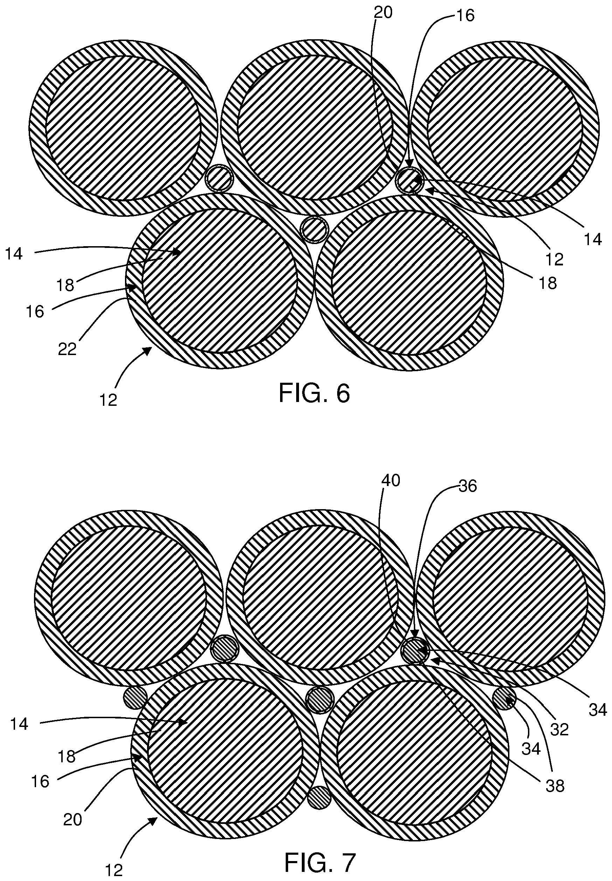

Particle cores 14 may have any suitable particle size or range of particle sizes or distribution of particle sizes. For example, the particle cores 14 may be selected to provide an average particle size that is represented by a normal or Gaussian type unimodal distribution around an average or mean, as illustrated generally in FIG. 1. In another example, particle cores 14 may be selected or mixed to provide a multimodal distribution of particle sizes, including a plurality of average particle core sizes, such as, for example, a homogeneous bimodal distribution of average particle sizes, as illustrated generally and schematically in FIG. 6. The selection of the distribution of particle core size may be used to determine, for example, the particle size and interparticle spacing 15 of the particles 12 of powder 10. In an exemplary embodiment, the particle cores 14 may have a unimodal distribution and an average particle diameter of about 5µm to about 300µm, more particularly about 80µm to about 120µm, and even more particularly about 100µm.

Particle cores 14 may have any suitable particle shape, including any regular or irregular geometric shape, or combination thereof. In an exemplary embodiment, particle cores 14 are substantially spheroidal electrochemically active metal particles. In another exemplary embodiment, particle cores 14 are substantially irregularly shaped ceramic particles. In yet another exemplary embodiment, particle cores 14 are carbon or other nanotube structures or hollow glass microspheres.

Each of the metallic, coated powder particles 12 of powder 10 also includes a metallic coating layer 16 that is disposed on particle core 14. Metallic coating layer 16 includes a metallic coating material 20. Metallic coating material 20 gives the powder particles 12 and powder 10 its metallic nature. Metallic coating layer 16 is a nanoscale coating layer. In an exemplary embodiment, metallic coating layer 16 may have a thickness of about 25nm to about 2500nm. The thickness of metallic coating layer 16 may vary over the surface of particle core 14, but will preferably have a substantially uniform thickness over the surface of particle core 14. In illustrative arrangements not in accordance with the present invention, metallic coating layer 16 may include a single layer, as illustrated in FIG. 2. In accordance with the present invention, metallic coating layer includes a plurality of layers as a multilayer coating structure, as illustrated in FIGS. 3-5 for up to four layers. In a single layer coating (as per the illustrative arrangement), or in each of the layers of a multilayer coating (as per the present invention), the metallic coating layer 16 may include a single constituent chemical element or compound, or may include a plurality of chemical elements or compounds. Where a layer includes a plurality of chemical constituents or compounds, they may have all manner of homogeneous or heterogeneous distributions, including a homogeneous or heterogeneous distribution of metallurgical phases. This may include a graded distribution where the relative amounts of the chemical constituents or compounds vary according to respective constituent profiles across the thickness of the layer. In both single layer and multilayer coatings 16, each of the respective layers, or combinations of them, may be used to provide a predetermined property to the powder particle 12 or a sintered powder compact formed therefrom. For example, the predetermined property may include the bond strength of the metallurgical bond between the particle core 14 and the coating material 20; the interdiffusion characteristics between the particle core 14 and metallic coating layer 16, including any interdiffusion between the layers of a multilayer coating layer 16; the interdiffusion characteristics between the various layers of a multilayer coating layer 16; the interdiffusion characteristics between the metallic coating layer 16 of one powder particle and that of an adjacent powder particle 12; the bond strength of the metallurgical bond between the metallic coating layers of adjacent sintered powder particles 12, including the outermost layers of multilayer coating layers; and the electrochemical activity of the coating layer 16.

Metallic coating layer 16 and coating material 20 have a melting temperature (T_{C}). As used herein, T_{C} includes the lowest temperature at which incipient melting or liquation or other forms of partial melting occur within coating material 20, regardless of whether coating material 20 comprises a pure metal, an alloy with multiple phases each having different melting temperatures or a composite, including a composite comprising a plurality of coating material layers having different melting temperatures.

Metallic coating material 20 may include any suitable metallic coating material 20 that provides a sinterable outer surface 21 that is configured to be sintered to an adjacent powder particle 12 that also has a metallic coating layer 16 and sinterable outer surface 21. In powders 10 that also include second or additional (coated or uncoated) particles 32, as described herein, the sinterable outer surface 21 of metallic coating layer 16 is also configured to be sintered to a sinterable outer surface 21 of second particles 32. In an exemplary embodiment, the powder particles 12 are sinterable at a predetermined sintering temperature (T_{S}) that is a function of the core material 18 and coating material 20, such that sintering of powder compact 200 is accomplished entirely in the solid state and where T_{S} is less than T_{P} and T_{C}. Sintering in the solid state limits particle core 14/metallic coating layer 16 interactions to solid state diffusion processes and metallurgical transport phenomena and limits growth of and provides control over the resultant interface between them. In contrast, for example, the introduction of liquid phase sintering would provide for rapid interdiffusion of the particle core 14/metallic coating layer 16 materials and make it difficult to limit the growth of and provide control over the resultant interface between them, and thus interfere with the formation of the desirable microstructure of particle compact 200 as described herein.

In an exemplary embodiment, core material 18 will be selected to provide a core chemical composition and the coating material 20 will be selected to provide a coating chemical composition and these chemical compositions will also be selected to differ from one another. In another exemplary embodiment, the core material 18 will be selected to provide a core chemical composition and the coating material 20 will be selected to provide a coating chemical composition and these chemical compositions will also be selected to differ from one another at their interface. Differences in the chemical compositions of coating material 20 and core material 18 may be selected to provide different dissolution rates and selectable and controllable dissolution of powder compacts 200 that incorporate them making them selectably and controllably dissolvable. This includes dissolution rates that differ in response to a changed condition in the wellbore, including an indirect or direct change in a wellbore fluid. In an exemplary embodiment, a powder compact 200 formed from powder 10 having chemical compositions of core material 18 and coating material 20 that make compact 200 is selectably dissolvable in a wellbore fluid in response to a changed wellbore condition that includes a change in temperature, change in pressure, change in flow rate, change in pH or change in chemical composition of the wellbore fluid, or a combination thereof. The selectable dissolution response to the changed condition may result from actual chemical reactions or processes that promote different rates of dissolution, but also encompass changes in the dissolution response that are associated with physical reactions or processes, such as changes in wellbore fluid pressure or flow rate.

In an arrangement of a powder 10 not in accordance with the present invention, particle core 14 includes Mg, Al, Mn or Zn, or a combination thereof, as core material 18, and more particularly may include pure Mg and Mg alloys, and metallic coating layer 16 includes a single layer of Al or Ni, or a combination thereof, as coating material 20, as illustrated in FIG. 2. Where metallic coating layer 16 includes a combination of two or more constituents, such as Al and Ni, the combination may include various graded or co-deposited structures of these materials where the amount of each constituent, and hence the composition of the layer, varies across the thickness of the layer, as also illustrated in FIG. 2.

In a powder 10, particle core 14 includes Mg, Al, Mn or Zn as core material 18, and more particularly may include pure Mg and Mg alloys as defined in claim 1.

Coating layer 16 includes two layers as core material 20, as illustrated in FIG. 3. The first layer 22 is disposed on the surface of particle core 14 and includes Al or Ni, or a combination thereof, as described herein. The second layer 24 is disposed on the surface of the first layer and includes Al, Zn, Mg, Mo, W, Cu, Fe, Ca, Co, Ta, Re or Ni, or a combination thereof, and the first layer has a chemical composition that is different than the chemical composition of the second layer. In general, first layer 22 will be selected to provide a strong metallurgical bond to particle core 14 and to limit interdiffusion between the particle core 14 and coating layer 16, particularly first layer 22. Second layer 24 may be selected to increase the strength of the metallic coating layer 16, or to provide a strong metallurgical bond and promote sintering with the second layer 24 of adjacent powder particles 12, or both. In an exemplary embodiment, the respective layers of metallic coating layer 16 may be selected to promote the selective and controllable dissolution of the coating layer 16 in response to a change in a property of the wellbore, including the wellbore fluid, as described herein. However, this is only exemplary and it will be appreciated that other selection criteria for the various layers may also be employed. For example, any of the respective layers may be selected to promote the selective and controllable dissolution of the coating layer 16 in response to a change in a property of the wellbore, including the wellbore fluid, as described herein. Exemplary embodiments of a two-layer metallic coating layers 16 for use on particles cores 14 comprising Mg include first/second layer combinations comprising Al/Ni and Al/W.

In an embodiment, coating layer 16 includes three layers, as illustrated in FIG. 4. The third layer 26 is disposed on the second layer 24 and may include Al, Mn, Fe, Co, Ni or a combination thereof. In a three-layer configuration, the composition of adjacent layers is different, such that the first layer has a chemical composition that is different than the second layer, and the second layer has a chemical composition that is different than the third layer. In an exemplary embodiment, first layer 22 may be selected to provide a strong metallurgical bond to particle core 14 and to limit interdiffusion between the particle core 14 and coating layer 16, particularly first layer 22. Second layer 24 may be selected to increase the strength of the metallic coating layer 16, or to limit interdiffusion between particle core 14 or first layer 22 and outer or third layer 26, or to promote adhesion and a strong metallurgical bond between third layer 26 and first layer 22, or any combination of them. Third layer 26 may be selected to provide a strong metallurgical bond and promote sintering with the third layer 26 of adjacent powder particles 12. However, this is only exemplary and it will be appreciated that other selection criteria for the various layers may also be employed. For example, any of the respective layers may be selected to promote the selective and controllable dissolution of the coating layer 16 in response to a change in a property of the wellbore, including the wellbore fluid, as described herein.

In still another embodiment, coating layer 16 includes four layers, as illustrated in FIG. 5. The fourth layer 28 may include Al, Mn, Fe, Co, Ni or a combination thereof. In the four layer configuration, the chemical composition of adjacent layers is different, such that the chemical composition of first layer 22 is different than the chemical composition of second layer 24, the chemical composition is of second layer 24 different than the chemical composition of third layer 26, and the chemical composition of third layer 26 is different than the chemical composition of fourth layer 28. In an exemplary embodiment, the selection of the various layers will be similar to that described for the three-layer configuration above with regard to the inner (first) and outer (fourth) layers, with the second and third layers available for providing enhanced interlayer adhesion, strength of the overall metallic coating layer 16, limited interlayer diffusion or selectable and controllable dissolution, or a combination thereof. However, this is only exemplary and it will be appreciated that other selection criteria for the various layers may also be employed. For example, any of the respective layers may be selected to promote the selective and controllable dissolution of the coating layer 16 in response to a change in a property of the wellbore, including the wellbore fluid, as described herein.

The thickness of the various layers in multi-layer configurations may be apportioned between the various layers in any manner so long as the sum of the layer thicknesses provide a nanoscale coating layer 16, including layer thicknesses as described herein. In one embodiment, the first layer 22 and outer layer (24, 26, or 28 depending on the number of layers) may be thicker than other layers, where present, due to the desire to provide sufficient material to promote the desired bonding of first layer 22 with the particle core 14, or the bonding of the outer layers of adjacent powder particles 12, during sintering of powder compact 200.

Powder 10 may also include an additional or second powder 30 interspersed in the plurality of powder particles 12, as illustrated in FIG. 7. In an exemplary embodiment, the second powder 30 includes a plurality of second powder particles 32. These second powder particles 32 may be selected to change a physical, chemical, mechanical or other property of a powder particle compact 200 formed from powder 10 and second powder 30, or a combination of such properties. In an exemplary embodiment, the property change may include an increase in the compressive strength of powder compact 200 formed from powder 10 and second powder 30. In another exemplary embodiment, the second powder 30 may be selected to promote the selective and controllable dissolution of in particle compact 200 formed from powder 10 and second powder 30 in response to a change in a property of the wellbore, including the wellbore fluid, as described herein. Second powder particles 32 may be uncoated or coated with a metallic coating layer 36. When coated, including single layer or multilayer coatings, the coating layer 36 of second powder particles 32 may comprise the same coating material 40 as coating material 20 of powder particles 12, or the coating material 40 may be different. The second powder particles 32 (uncoated) or particle cores 34 may include any suitable material to provide the desired benefit, including many metals. In an exemplary embodiment, when coated powder particles 12 comprising Mg, Al, Mn or Zn, or a combination thereof are employed, suitable second powder particles 32 may include Ni, W, Cu, Co or Fe, or a combination thereof. Since second powder particles 32 will also be configured for solid state sintering to powder particles 12 at the predetermined sintering temperature (T_{S}), particle cores 34 will have a melting temperature T_{AP} and any coating layers 36 will have a second melting temperature T_{AC}, where T_{S} is less than T_{AP} and T_{AC}. It will also be appreciated that second powder 30 is not limited to one additional powder particle 32 type (i.e., a second powder particle), but may include a plurality of additional powder particles 32 (i.e., second, third, fourth, etc. types of additional powder particles 32) in any number.

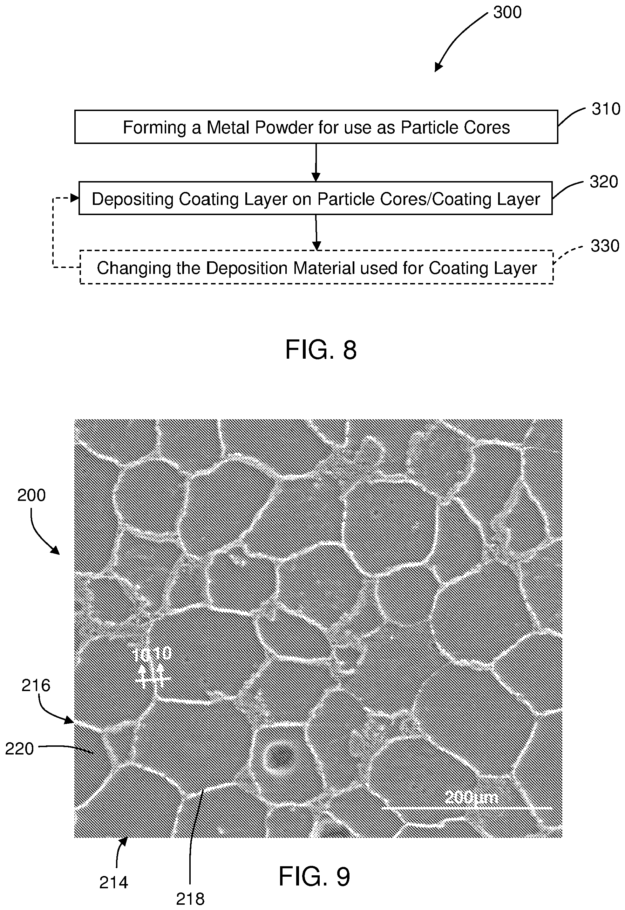

Referring to FIG. 8, an exemplary embodiment of a method 300 of making a metallic powder 10 is disclosed. Method 300 includes forming 310 a plurality of particle cores 14 as described herein. Method 300 also includes depositing 320 a metallic coating layer 16 on each of the plurality of particle cores 14. Depositing 320 is the process by which coating layer 16 is disposed on particle core 14 as described herein.

Forming 310 of particle cores 14 may be performed by any suitable method for forming a plurality of particle cores 14 of the desired core material 18, which essentially comprise methods of forming a powder of core material 18. Suitable powder forming methods include mechanical methods; including machining, milling, impacting and other mechanical methods for forming the metal powder; chemical methods, including chemical decomposition, precipitation from a liquid or gas, solid-solid reactive synthesis and other chemical powder forming methods; atomization methods, including gas atomization, liquid and water atomization, centrifugal atomization, plasma atomization and other atomization methods for forming a powder; and various evaporation and condensation methods. In an exemplary embodiment, particle cores 14 comprising Mg may be fabricated using an atomization method, such as vacuum spray forming or inert gas spray forming.

Depositing 320 of metallic coating layers 16 on the plurality of particle cores 14 may be performed using any suitable deposition method, including various thin film deposition methods, such as, for example, chemical vapor deposition and physical vapor deposition methods. In an exemplary embodiment, depositing 320 of metallic coating layers 16 is performed using fluidized bed chemical vapor deposition (FBCVD). Depositing 320 of the metallic coating layers 16 by FBCVD includes flowing a reactive fluid as a coating medium that includes the desired metallic coating material 20 through a bed of particle cores 14 fluidized in a reactor vessel under suitable conditions, including temperature, pressure and flow rate conditions and the like, sufficient to induce a chemical reaction of the coating medium to produce the desired metallic coating material 20 and induce its deposition upon the surface of particle cores 14 to form coated powder particles 12. The reactive fluid selected will depend upon the metallic coating material 20 desired, and will typically comprise an organometallic compound that includes the metallic material to be deposited, such as nickel tetracarbonyl (Ni(CO)₄), tungsten hexafluoride (WF₆), and triethyl aluminum (C₆H₁₅Al), that is transported in a carrier fluid, such as helium or argon gas. The reactive fluid, including carrier fluid, causes at least a portion of the plurality of particle cores 14 to be suspended in the fluid, thereby enabling the entire surface of the suspended particle cores 14 to be exposed to the reactive fluid, including, for example, a desired organometallic constituent, and enabling deposition of metallic coating material 20 and coating layer 16 over the entire surfaces of particle cores 14 such that they each become enclosed forming coated particles 12 having metallic coating layers 16, as described herein. As also described herein, each metallic coating layer 16 may include a plurality of coating layers. Coating material 20 may be deposited in multiple layers to form a multilayer metallic coating layer 16 by repeating the step of depositing 320 described above and changing 330 the reactive fluid to provide the desired metallic coating material 20 for each subsequent layer, where each subsequent layer is deposited on the outer surface of particle cores 14 that already include any previously deposited coating layer or layers that make up metallic coating layer 16. The metallic coating materials 20 of the respective layers (e.g., 22, 24, 26, 28, etc.) may be different from one another, and the differences may be provided by utilization of different reactive media that are configured to produce the desired metallic coating layers 16 on the particle cores 14 in the fluidize bed reactor.

As illustrated in FIGS. 1 and 9, particle core 14 and core material 18 and metallic coating layer 16 and coating material 20 may be selected to provide powder particles 12 and a powder 10 that is configured for compaction and sintering to provide a powder compact 200 that is lightweight (i.e., having a relatively low density), high-strength and is selectably and controllably removable from a wellbore in response to a change in a wellbore property, including being selectably and controllably dissolvable in an appropriate wellbore fluid, including various wellbore fluids as disclosed herein. (Note that the powder compact 200 described herein is not part of the present invention and may or may not employ the metallic powder of the invention.) Powder compact 200 includes a substantially-continuous, cellular nanomatrix 216 of a nanomatrix material 220 having a plurality of dispersed particles 214 dispersed throughout the cellular nanomatrix 216. The substantially-continuous cellular nanomatrix 216 and nanomatrix material 220 formed of sintered metallic coating layers 16 is formed by the compaction and sintering of the plurality of metallic coating layers 16 of the plurality of powder particles 12. The chemical composition of nanomatrix material 220 may be different than that of coating material 20 due to diffusion effects associated with the sintering as described herein. Powder metal compact 200 also includes a plurality of dispersed particles 214 that comprise particle core material 218. Dispersed particle cores 214 and core material 218 correspond to and are formed from the plurality of particle cores 14 and core material 18 of the plurality of powder particles 12 as the metallic coating layers 16 are sintered together to form nanomatrix 216. The chemical composition of core material 218 may be different than that of core material 18 due to diffusion effects associated with sintering as described herein.

As used herein, the use of the term substantially-continuous cellular nanomatrix 216 does not connote the major constituent of the powder compact, but rather refers to the minority constituent or constituents, whether by weight or by volume. This is distinguished from most matrix composite materials where the matrix comprises the majority constituent by weight or volume. The use of the term substantially-continuous, cellular nanomatrix is intended to describe the extensive, regular, continuous and interconnected nature of the distribution of nanomatrix material 220 within powder compact 200. As used herein, "substantially-continuous" describes the extension of the nanomatrix material throughout powder compact 200 such that it extends between and envelopes substantially all of the dispersed particles 214. Substantially-continuous is used to indicate that complete continuity and regular order of the nanomatrix around each dispersed particle 214 is not required. For example, defects in the coating layer 16 over particle core 14 on some powder particles 12 may cause bridging of the particle cores 14 during sintering of the powder compact 200, thereby causing localized discontinuities to result within the cellular nanomatrix 216, even though in the other portions of the powder compact the nanomatrix is substantially continuous and exhibits the structure described herein. As used herein, "cellular" is used to indicate that the nanomatrix defines a network of generally repeating, interconnected, compartments or cells of nanomatrix material 220 that encompass and also interconnect the dispersed particles 214. As used herein, "nanomatrix" is used to describe the size or scale of the matrix, particularly the thickness of the matrix between adjacent dispersed particles 214. The metallic coating layers that are sintered together to form the nanomatrix are themselves nanoscale thickness coating layers. Since the nanomatrix at most locations, other than the intersection of more than two dispersed particles 214, generally comprises the interdiffusion and bonding of two coating layers 16 from adjacent powder particles 12 having nanoscale thicknesses, the matrix formed also has a nanoscale thickness (e.g., approximately two times the coating layer thickness as described herein) and is thus described as a nanomatrix. Further, the use of the term dispersed particles 214 does not connote the minor constituent of powder compact 200, but rather refers to the majority constituent or constituents, whether by weight or by volume. The use of the term dispersed particle is intended to convey the discontinuous and discrete distribution of particle core material 218 within powder compact 200.

Powder compact 200 may have any desired shape or size, including that of a cylindrical billet or bar that may be machined or otherwise used to form useful articles of manufacture, including various wellbore tools and components. The pressing used to form precursor powder compact 100 and sintering and pressing processes used to form powder compact 200 and deform the powder particles 12, including particle cores 14 and coating layers 16, to provide the full density and desired macroscopic shape and size of powder compact 200 as well as its microstructure. The microstructure of powder compact 200 includes an equiaxed configuration of dispersed particles 214 that are dispersed throughout and embedded within the substantially-continuous, cellular nanomatrix 216 of sintered coating layers. This microstructure is somewhat analogous to an equiaxed grain microstructure with a continuous grain boundary phase, except that it does not require the use of alloy constituents having thermodynamic phase equilibria properties that are capable of producing such a structure. Rather, this equiaxed dispersed particle structure and cellular nanomatrix 216 of sintered metallic coating layers 16 may be produced using constituents where thermodynamic phase equilibrium conditions would not produce an equiaxed structure. The equiaxed morphology of the dispersed particles 214 and cellular network 216 of particle layers results from sintering and deformation of the powder particles 12 as they are compacted and interdiffuse and deform to fill the interparticle spaces 15 (FIG. 1). The sintering temperatures and pressures may be selected to ensure that the density of powder compact 200 achieves substantially full theoretical density.

In an exemplary embodiment as illustrated in FIGS. 1 and 9, dispersed particles 214 are formed from particle cores 14 dispersed in the cellular nanomatrix 216 of sintered metallic coating layers 16, and the nanomatrix 216 includes a solid-state metallurgical bond 217 or bond layer 219, as illustrated schematically in FIG. 10, extending between the dispersed particles 214 throughout the cellular nanomatrix 216 that is formed at a sintering temperature (T_{S}), where T_{S} is less than T_{C} and T_{P}. As indicated, solid-state metallurgical bond 217 is formed in the solid state by solid-state interdiffusion between the coating layers 16 of adjacent powder particles 12 that are compressed into touching contact during the compaction and sintering processes used to form powder compact 200, as described herein. As such, sintered coating layers 16 of cellular nanomatrix 216 include a solid-state bond layer 219 that has a thickness (t) defined by the extent of the interdiffusion of the coating materials 20 of the coating layers 16, which will in turn be defined by the nature of the coating layers 16, including whether they are single or multilayer coating layers, whether they have been selected to promote or limit such interdiffusion, and other factors, as described herein, as well as the sintering and compaction conditions, including the sintering time, temperature and pressure used to form powder compact 200.

As nanomatrix 216 is formed, including bond 217 and bond layer 219, the chemical composition or phase distribution, or both, of metallic coating layers 16 may change. Nanomatrix 216 also has a melting temperature (T_{M}). As used herein, T_{M} includes the lowest temperature at which incipient melting or liquation or other forms of partial melting will occur within nanomatrix 216, regardless of whether nanomatrix material 220 comprises a pure metal, an alloy with multiple phases each having different melting temperatures or a composite, including a composite comprising a plurality of layers of various coating materials having different melting temperatures, or a combination thereof, or otherwise. As dispersed particles 214 and particle core materials 218 are formed in conjunction with nanomatrix 216, diffusion of constituents of metallic coating layers 16 into the particle cores 14 is also possible, which may result in changes in the chemical composition or phase distribution, or both, of particle cores 14. As a result, dispersed particles 214 and particle core materials 218 may have a melting temperature (T_{DP}) that is different than T_{P}. As used herein, T_{DP} includes the lowest temperature at which incipient melting or liquation or other forms of partial melting will occur within dispersed particles 214, regardless of whether particle core material 218 comprise a pure metal, an alloy with multiple phases each having different melting temperatures or a composite, or otherwise. Powder compact 200 is formed at a sintering temperature (T_{S}), where T_{S} is less than T_{C},T_{P}, T_{M} and T_{DP}.

Dispersed particles 214 may comprise any of the materials described herein for particle cores 14, even though the chemical composition of dispersed particles 214 may be different due to diffusion effects as described herein. In an exemplary embodiment, dispersed particles 214 are formed from particle cores 14 comprising materials having a standard oxidation potential greater than or equal to Zn, including Mg, Al, Zn or Mn, or a combination thereof, may include various binary, tertiary and quaternary alloys or other combinations of these constituents as disclosed herein in conjunction with particle cores 14. Of these materials, those having dispersed particles 214 comprising Mg and the nanomatrix 216 formed from the metallic coating materials 16 described herein are particularly useful. Dispersed particles 214 and particle core material 218 of Mg, Al, Zn or Mn, or a combination thereof, may also include a rare earth element, or a combination of rare earth elements as disclosed herein in conjunction with particle cores 14.

In another exemplary embodiment, dispersed particles 214 are formed from particle cores 14 comprising metals that are less electrochemically active than Zn or non-metallic materials. Suitable non-metallic materials include ceramics, glasses (e.g., hollow glass microspheres) or carbon, or a combination thereof, as described herein.

Dispersed particles 214 of powder compact 200 may have any suitable particle size, including the average particle sizes described herein for particle cores 14.

Dispersed particles 214 may have any suitable shape depending on the shape selected for particle cores 14 and powder particles 12, as well as the method used to sinter and compact powder 10. In an exemplary embodiment, powder particles 12 may be spheroidal or substantially spheroidal and dispersed particles 214 may include an equiaxed particle configuration as described herein.

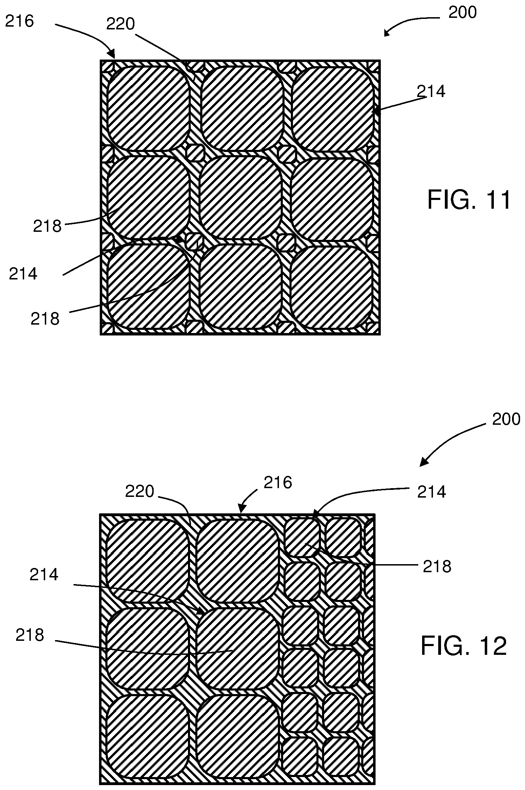

The nature of the dispersion of dispersed particles 214 may be affected by the selection of the powder 10 or powders 10 used to make particle compact 200. In one exemplary embodiment, a powder 10 having a unimodal distribution of powder particle 12 sizes may be selected to form powder compact 200 and will produce a substantially homogeneous unimodal dispersion of particle sizes of dispersed particles 214 within cellular nanomatrix 216, as illustrated generally in FIG. 9. In another exemplary embodiment, a plurality of powders 10 having a plurality of powder particles with particle cores 14 that have the same core materials 18 and different core sizes and the same coating material 20 may be selected and uniformly mixed as described herein to provide a powder 10 having a homogenous, multimodal distribution of powder particle 12 sizes, and may be used to form powder compact 200 having a homogeneous, multimodal dispersion of particle sizes of dispersed particles 214 within cellular nanomatrix 216, as illustrated schematically in FIGS. 6 and 11. Similarly, in yet another exemplary embodiment, a plurality of powders 10 having a plurality of particle cores 14 that may have the same core materials 18 and different core sizes and the same coating material 20 may be selected and distributed in a non-uniform manner to provide a non-homogenous, multimodal distribution of powder particle sizes, and may be used to form powder compact 200 having a non-homogeneous, multimodal dispersion of particle sizes of dispersed particles 214 within cellular nanomatrix 216, as illustrated schematically in FIG. 12. The selection of the distribution of particle core size may be used to determine, for example, the particle size and interparticle spacing of the dispersed particles 214 within the cellular nanomatrix 216 of powder compacts 200 made from powder 10.

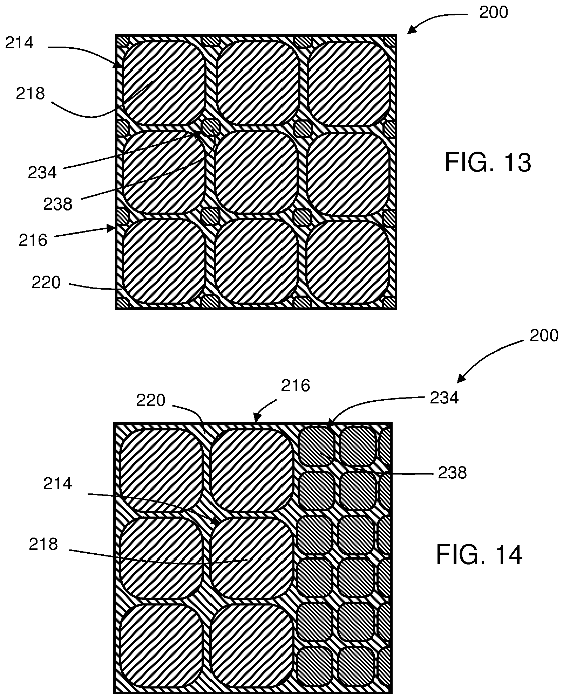

As illustrated generally in FIGS. 7 and 13, powder metal compact 200 may also be formed using coated metallic powder 10 and an additional or second powder 30, as described herein. The use of an additional powder 30 provides a powder compact 200 that also includes a plurality of dispersed second particles 234, as described herein, that are dispersed within the nanomatrix 216 and are also dispersed with respect to the dispersed particles 214. Dispersed second particles 234 may be formed from coated or uncoated second powder particles 32, as described herein. In an exemplary embodiment, coated second powder particles 32 may be coated with a coating layer 36 that is the same as coating layer 16 of powder particles 12, such that coating layers 36 also contribute to the nanomatrix 216. In another exemplary embodiment, the second powder particles 232 may be uncoated such that dispersed second particles 234 are embedded within nanomatrix 216. As disclosed herein, powder 10 and additional powder 30 may be mixed to form a homogeneous dispersion of dispersed particles 214 and dispersed second particles 234, as illustrated in FIG. 13, or to form a non-homogeneous dispersion of these particles, as illustrated in FIG. 14. The dispersed second particles 234 may be formed from any suitable additional powder 30 that is different from powder 10, either due to a compositional difference in the particle core 34, or coating layer 36, or both of them, and may include any of the materials disclosed herein for use as second powder 30 that are different from the powder 10 that is selected to form powder compact 200. In an exemplary embodiment, dispersed second particles 234 may include Fe, Ni, Co or Cu, or oxides, nitrides or carbides thereof, or a combination of any of the aforementioned materials.

Nanomatrix 216 is a substantially-continuous, cellular network of metallic coating layers 16 that are sintered to one another. The thickness of nanomatrix 216 will depend on the nature of the powder 10 or powders 10 used to form powder compact 200, as well as the incorporation of any second powder 30, particularly the thicknesses of the coating layers associated with these particles. In an exemplary embodiment, the thickness of nanomatrix 216 is substantially uniform throughout the microstructure of powder compact 200 and comprises about two times the thickness of the coating layers 16 of powder particles 12. In another exemplary embodiment, the cellular network 216 has a substantially uniform average thickness between dispersed particles 214 of about 50nm to about 5000nm.

Nanomatrix 216 is formed by sintering metallic coating layers 16 of adjacent particles to one another by interdiffusion and creation of bond layer 219 as described herein. Metallic coating layers 16 may be single layer or multilayer structures, and they may be selected to promote or inhibit diffusion, or both, within the layer or between the layers of metallic coating layer 16, or between the metallic coating layer 16 and particle core 14, or between the metallic coating layer 16 and the metallic coating layer 16 of an adjacent powder particle, the extent of interdiffusion of metallic coating layers 16 during sintering may be limited or extensive depending on the coating thicknesses, coating material or materials selected, the sintering conditions and other factors. Given the potential complexity of the interdiffusion and interaction of the constituents, description of the resulting chemical composition of nanomatrix 216 and nanomatrix material 220 may be simply understood to be a combination of the constituents of coating layers 16 that may also include one or more constituents of dispersed particles 214, depending on the extent of interdiffusion, if any, that occurs between the dispersed particles 214 and the nanomatrix 216. Similarly, the chemical composition of dispersed particles 214 and particle core material 218 may be simply understood to be a combination of the constituents of particle core 14 that may also include one or more constituents of nanomatrix 216 and nanomatrix material 220, depending on the extent of interdiffusion, if any, that occurs between the dispersed particles 214 and the nanomatrix 216.

In an exemplary embodiment, the nanomatrix material 220 has a chemical composition and the particle core material 218 has a chemical composition that is different from that of nanomatrix material 220, and the differences in the chemical compositions may be configured to provide a selectable and controllable dissolution rate, including a selectable transition from a very low dissolution rate to a very rapid dissolution rate, in response to a controlled change in a property or condition of the wellbore proximate the compact 200, including a property change in a wellbore fluid that is in contact with the powder compact 200, as described herein. Nanomatrix 216 may be formed from powder particles 12 having single layer and multilayer coating layers 16. This design flexibility provides a large number of material combinations, particularly in the case of multilayer coating layers 16, that can be utilized to tailor the cellular nanomatrix 216 and composition of nanomatrix material 220 by controlling the interaction of the coating layer constituents, both within a given layer, as well as between a coating layer 16 and the particle core 14 with which it is associated or a coating layer 16 of an adjacent powder particle 12. Several exemplary embodiments that demonstrate this flexibility are provided below.

As illustrated in FIG. 10, in an exemplary embodiment, powder compact 200 is formed from powder particles 12 where the coating layer 16 comprises a single layer, and the resulting nanomatrix 216 between adjacent ones of the plurality of dispersed particles 214 comprises the single metallic coating layer 16 of one powder particle 12, a bond layer 219 and the single coating layer 16 of another one of the adjacent powder particles 12. The thickness (t) of bond layer 219 is determined by the extent of the interdiffusion between the single metallic coating layers 16, and may encompass the entire thickness of nanomatrix 216 or only a portion thereof. In one exemplary embodiment of powder compact 200 formed using a single layer powder 10, powder compact 200 may include dispersed particles 214 comprising Mg, Al, Zn or Mn, or a combination thereof, as described herein, and nanomatrix 216 may include Al, Zn, Mn, Mg, Mo, W, Cu, Fe, Si, Ca, Co, Ta, Re or Ni, or an oxide, carbide or nitride thereof, or a combination of any of the aforementioned materials, including combinations where the nanomatrix material 220 of cellular nanomatrix 216, including bond layer 219, has a chemical composition and the core material 218 of dispersed particles 214 has a chemical composition that is different than the chemical composition of nanomatrix material 216. The difference in the chemical composition of the nanomatrix material 220 and the core material 218 may be used to provide selectable and controllable dissolution in response to a change in a property of a wellbore, including a wellbore fluid, as described herein. In a further exemplary embodiment of a powder compact 200 formed from a powder 10 having a single coating layer configuration, dispersed particles 214 include Mg, Al, Zn or Mn, or a combination thereof, and the cellular nanomatrix 216 includes Al or Ni, or a combination thereof.

As illustrated in FIG. 15, in another exemplary embodiment, powder compact 200 is formed from powder particles 12 where the coating layer 16 comprises a multilayer coating layer 16 having a plurality of coating layers, and the resulting nanomatrix 216 between adjacent ones of the plurality of dispersed particles 214 comprises the plurality of layers (t) comprising the coating layer 16 of one particle 12, a bond layer 219, and the plurality of layers comprising the coating layer 16 of another one of powder particles 12. In FIG. 15, this is illustrated with a two-layer metallic coating layer 16, but it will be understood that the plurality of layers of multi-layer metallic coating layer 16 may include any desired number of layers. The thickness (t) of the bond layer 219 is again determined by the extent of the interdiffusion between the plurality of layers of the respective coating layers 16, and may encompass the entire thickness of nanomatrix 216 or only a portion thereof. In this embodiment, the plurality of layers comprising each coating layer 16 may be used to control interdiffusion and formation of bond layer 219 and thickness (t).

In one exemplary embodiment of a powder compact 200 made using powder particles 12 with multilayer coating layers 16, the compact includes dispersed particles 214 comprising Mg, Al, Zn or Mn, or a combination thereof, as described herein, and nanomatrix 216 comprises a cellular network of sintered two-layer coating layers 16, as shown in FIG. 3, comprising first layers 22 that are disposed on the dispersed particles 214 and a second layers 24 that are disposed on the first layers 22. First layers 22 include Al or Ni, or a combination thereof, and second layers 24 include Al, Zn, Mn, Mg, Mo, W, Cu, Fe, Si, Ca, Co, Ta, Re or Ni, or a combination thereof. In these configurations, materials of dispersed particles 214 and multilayer coating layer 16 used to form nanomatrix 216 are selected so that the chemical compositions of adjacent materials are different (e.g. dispersed particle/first layer and first layer/second layer).

In another exemplary embodiment of a powder compact 200 made using powder particles 12 with multilayer coating layers 16, the compact includes dispersed particles 214 comprising Mg, Al, Zn or Mn, or a combination thereof, as described herein, and nanomatrix 216 comprises a cellular network of sintered three-layer metallic coating layers 16, as shown in FIG. 4, comprising first layers 22 that are disposed on the dispersed particles 214, second layers 24 that are disposed on the first layers 22 and third layers 26 that are disposed on the second layers 24. First layers 22 include Al or Ni, or a combination thereof; second layers 24 include Al, Zn, Mn, Mg, Mo, W, Cu, Fe, Si, Ca, Co, Ta, Re or Ni, or an oxide, nitride or carbide thereof, or a combination of any of the aforementioned second layer materials; and the third layers include Al, Zn, Mn, Mg, Mo, W, Cu, Fe, Si, Ca, Co, Ta, Re or Ni, or a combination thereof. The selection of materials is analogous to the selection considerations described herein for powder compact 200 made using two-layer coating layer powders, but must also be extended to include the material used for the third coating layer.

In yet another exemplary embodiment of a powder compact 200 made using powder particles 12 with multilayer coating layers 16, the compact includes dispersed particles 214 comprising Mg, Al, Zn or Mn, or a combination thereof, as described herein, and nanomatrix 216 comprise a cellular network of sintered four-layer coating layers 16 comprising first layers 22 that are disposed on the dispersed particles 214; second layers 24 that are disposed on the first layers 22; third layers 26 that are disposed on the second layers 24 and fourth layers 28 that are disposed on the third layers 26. First layers 22 include Al or Ni, or a combination thereof; second layers 24 include Al, Zn, Mn, Mg, Mo, W, Cu, Fe, Si, Ca, Co, Ta, Re or Ni, or an oxide, nitride or carbide thereof, or a combination of any of the aforementioned second layer materials; third layers include Al, Zn, Mn, Mg, Mo, W, Cu, Fe, Si, Ca, Co, Ta, Re or Ni, or an oxide, nitride or carbide thereof, or a combination of any of the aforementioned third layer materials; and fourth layers include Al, Mn, Fe, Co or Ni, or a combination thereof. The selection of materials is analogous to the selection considerations described herein for powder compacts 200 made using two-layer coating layer powders, but must also be extended to include the material used for the third and fourth coating layers.

In another exemplary embodiment of a powder compact 200, dispersed particles 214 comprise a metal having a standard oxidation potential less than Zn or a non-metallic material, or a combination thereof, as described herein, and nanomatrix 216 comprises a cellular network of sintered metallic coating layers 16. Suitable non-metallic materials include various ceramics, glasses or forms of carbon, or a combination thereof. Further, in powder compacts 200 that include dispersed particles 214 comprising these metals or non-metallic materials, nanomatrix 216 may include Al, Zn, Mn, Mg, Mo, W, Cu, Fe, Si, Ca, Co, Ta, Re or Ni, or an oxide, carbide or nitride thereof, or a combination of any of the aforementioned materials as nanomatrix material 220.

Referring to FIG. 16, sintered powder compact 200 may comprise a sintered precursor powder compact 100 that includes a plurality of deformed, mechanically bonded powder particles as described herein. Precursor powder compact 100 may be formed by compaction of powder 10 to the point that powder particles 12 are pressed into one another, thereby deforming them and forming interparticle mechanical or other bonds 110 associated with this deformation sufficient to cause the deformed powder particles 12 to adhere to one another and form a green-state powder compact having a green density that is less than the theoretical density of a fully-dense compact of powder 10, due in part to interparticle spaces 15. Compaction may be performed, for example, by isostatically pressing powder 10 at room temperature to provide the deformation and interparticle bonding of powder particles 12 necessary to form precursor powder compact 100.

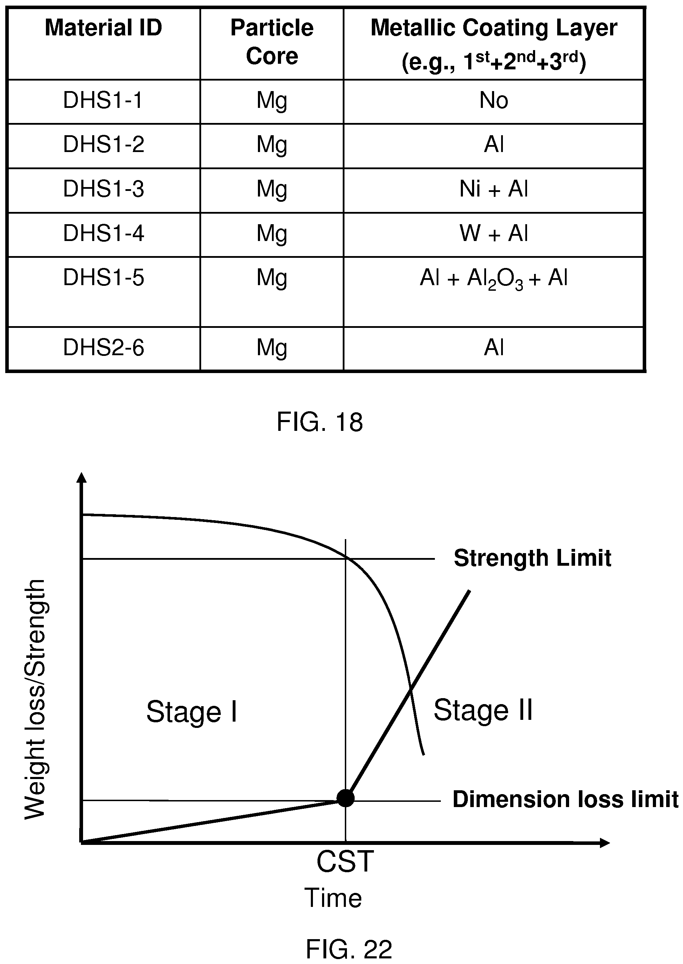

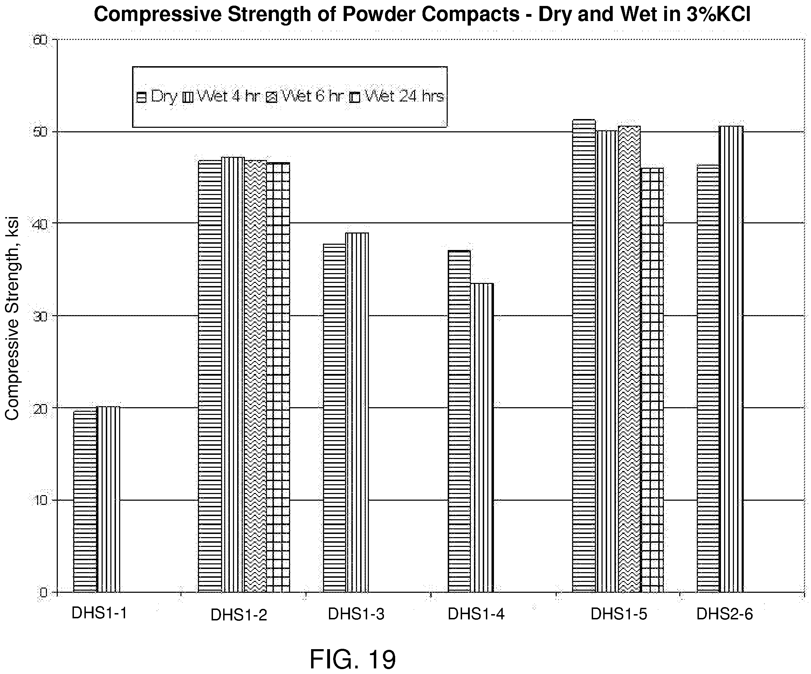

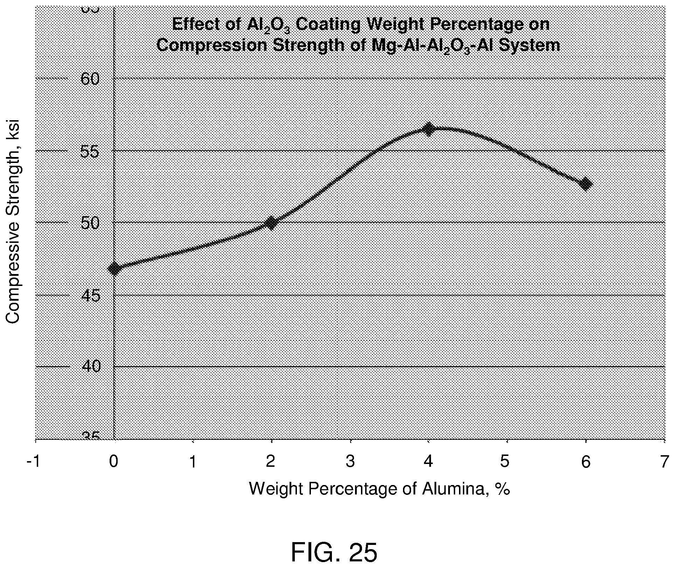

Sintered and forged powder compacts 200 that include dispersed particles 214 comprising Mg and nanomatrix 216 comprising various nanomatrix materials as described herein have demonstrated an excellent combination of mechanical strength and low density that exemplify the lightweight, high-strength materials disclosed herein. Examples of powder compacts 200 that have pure Mg dispersed particles 214 and various nanomatrices 216 formed from powders 10 having pure Mg particle cores 14 and various single and multilayer metallic coating layers 16 that include Al, Ni, W or Al₂O₃, or a combination thereof, and that have been made using the method 400 disclosed herein, are listed in a table as FIG. 18, material DHS1-3 employing a powder according to the invention and the others corresponding to reference examples. These powders compacts 200 have been subjected to various mechanical and other testing, including density testing, and their dissolution and mechanical property degradation behavior has also been characterized as disclosed herein. The results indicate that these materials may be configured to provide a wide range of selectable and controllable corrosion or dissolution behavior from very low corrosion rates to extremely high corrosion rates, particularly corrosion rates that are both lower and higher than those of powder compacts that do not incorporate the cellular nanomatrix, such as a compact formed from pure Mg powder through the same compaction and sintering processes in comparison to those that include pure Mg dispersed particles in the various cellular nanomatrices described herein. These powder compacts 200 may also be configured to provide substantially enhanced properties as compared to powder compacts formed from pure Mg particles that do not include the nanoscale coatings described herein. For example, referring to FIGS. 18 and 19, powder compacts 200 that include dispersed particles 214 comprising Mg and nanomatrix 216 comprising various nanomatrix materials 220 described herein have demonstrated room temperature compressive strengths of at least about 37 ksi, and have further demonstrated room temperature compressive strengths in excess of about 50 ksi, both dry and immersed in a solution of 3% KCl at 200°F. In contrast, powder compacts formed from pure Mg powders have a compressive strength of about 20 ksi or less. Strength of the nanomatrix powder metal compact 200 can be further improved by optimizing powder 10, particularly the weight percentage of the nanoscale metallic coating layers 16 that are used to form cellular nanomatrix 216. For example, FIG. 25 shows the effect of varying the weight percentage (wt.%), i.e., thickness, of an alumina coating on the room temperature compressive strength of a powder compact 200 of a cellular nanomatrix 216 formed from coated powder particles 12 that include a multilayer (Al/Al₂O₃/Al) metallic coating layer 16 on pure Mg particle cores 14. In this example, optimal strength is achieved at 4 wt% of alumina, which represents an increase of 21% as compared to that of 0 wt% alumina.

Powder compacts 200 comprising dispersed particles 214 that include Mg and nanomatrix 216 that includes various nanomatrix materials as described herein have also demonstrated a room temperature sheer strength of at least about 20 ksi. This is in contrast with powder compacts formed from pure Mg powders which have room temperature sheer strengths of about 8 ksi.

Powder compacts 200 of the types disclosed herein are able to achieve an actual density that is substantially equal to the predetermined theoretical density of a compact material based on the composition of powder 10, including relative amounts of constituents of particle cores 14 and metallic coating layer 16, and are also described herein as being fully-dense powder compacts. Powder compacts 200 comprising dispersed particles that include Mg and nanomatrix 216 that includes various nanomatrix materials as described herein have demonstrated actual densities of about 1.738 g/cm³ to about 2.50 g/cm³, which are substantially equal to the predetermined theoretical densities, differing by at most 4% from the predetermined theoretical densities.

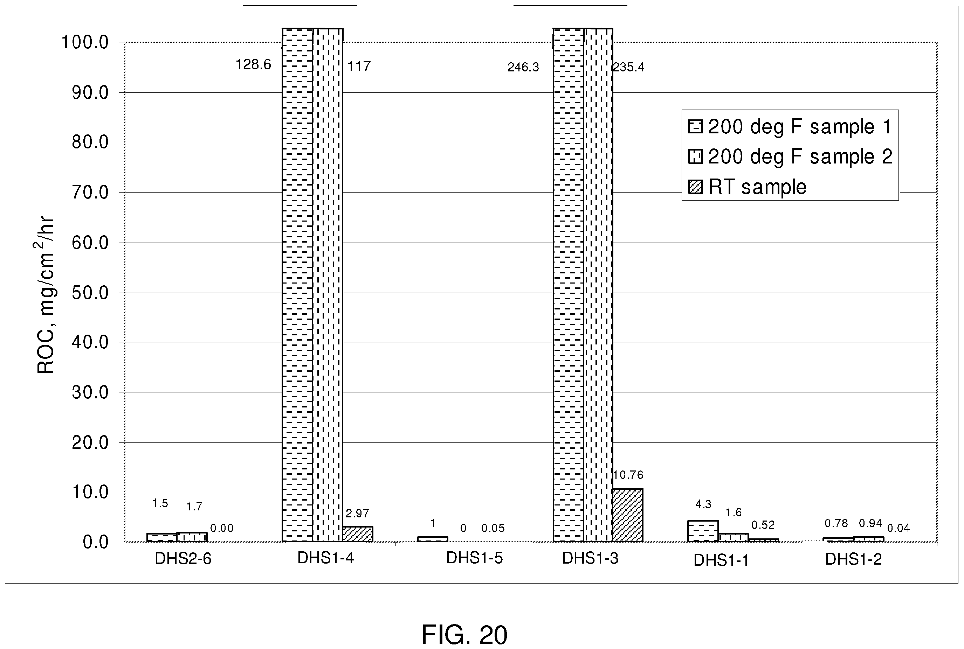

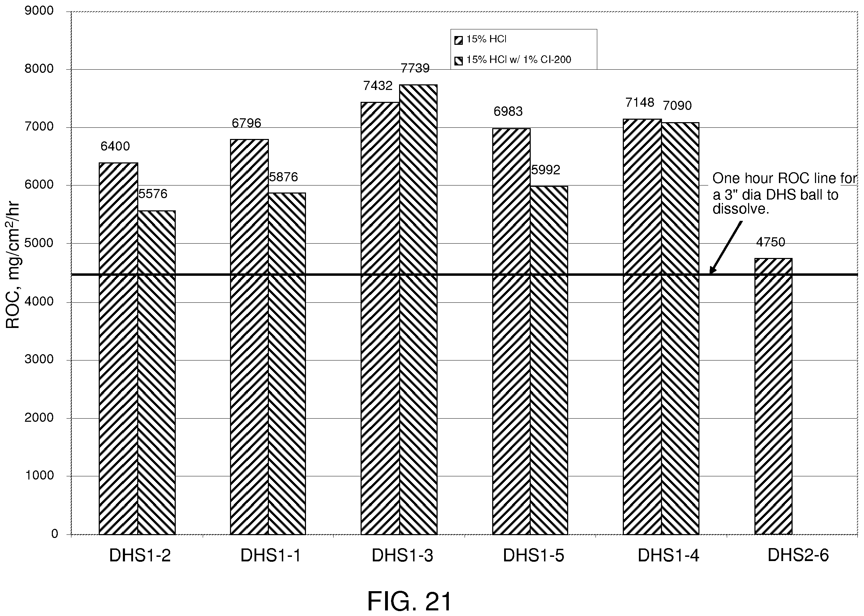

Powder compacts 200 as disclosed herein may be configured to be selectively and controllably dissolvable in a wellbore fluid in response to a changed condition in a wellbore. Examples of the changed condition that may be exploited to provide selectable and controllable dissolvability include a change in temperature, change in pressure, change in flow rate, change in pH or change in chemical composition of the wellbore fluid, or a combination thereof. An example of a changed condition comprising a change in temperature includes a change in well bore fluid temperature. For example, referring to FIGS. 18 and 20, powder compacts 200 comprising dispersed particles 214 that include Mg and cellular nanomatrix 216 that includes various nanomatrix materials as described herein have relatively low rates of corrosion in a 3% KCl solution at room temperature that ranges from about 0 to about 11 mg/cm²/hr as compared to relatively high rates of corrosion at 200°F that range from about 1 to about 246 mg/cm²/hr depending on different nanoscale coating layers 16. An example of a changed condition comprising a change in chemical composition includes a change in a chloride ion concentration or pH value, or both, of the wellbore fluid. For example, referring to FIGS. 18 and 21, powder compacts 200 comprising dispersed particles 214 that include Mg and nanomatrix 216 that includes various nanoscale coatings described herein demonstrate corrosion rates in 15% HCl that range from about 4750 mg/cm²/hr to about 7432 mg/cm²/hr. Thus, selectable and controllable dissolvability in response to a changed condition in the wellbore, namely the change in the wellbore fluid chemical composition from KCl to HCl, may be used to achieve a characteristic response as illustrated graphically in FIG. 22, which illustrates that at a selected predetermined critical service time (CST) a changed condition may be imposed upon powder compact 200 as it is applied in a given application, such as a wellbore environment, that causes a controllable change in a property of powder compact 200 in response to a changed condition in the environment in which it is applied. For example, at a predetermined CST changing a wellbore fluid that is in contact with powder contact 200 from a first fluid (e.g. KCl) that provides a first corrosion rate and an associated weight loss or strength as a function of time to a second wellbore fluid (e.g., HCl) that provides a second corrosion rate and associated weight loss and strength as a function of time, wherein the corrosion rate associated with the first fluid is much less than the corrosion rate associated with the second fluid. This characteristic response to a change in wellbore fluid conditions may be used, for example, to associate the critical service time with a dimension loss limit or a minimum strength needed for a particular application, such that when a wellbore tool or component formed from powder compact 200 as disclosed herein is no longer needed in service in the wellbore (e.g., the CST) the condition in the wellbore (e.g., the chloride ion concentration of the wellbore fluid) may be changed to cause the rapid dissolution of powder compact 200 and its removal from the wellbore. In the example described above, powder compact 200 is selectably dissolvable at a rate that ranges from about 0 to about 7000 mg/cm²/hr. This range of response provides, for example the ability to remove a 3 inch diameter ball formed from this material from a wellbore by altering the wellbore fluid in less than one hour. The selectable and controllable dissolvability behavior described above, coupled with the excellent strength and low density properties described herein, define a new engineered dispersed particle-nanomatrix material that is configured for contact with a fluid and configured to provide a selectable and controllable transition from one of a first strength condition to a second strength condition that is lower than a functional strength threshold, or a first weight loss amount to a second weight loss amount that is greater than a weight loss limit, as a function of time in contact with the fluid. The dispersed particle-nanomatrix composite is characteristic of the powder compacts 200 described herein and includes a cellular nanomatrix 216 of nanomatrix material 220, a plurality of dispersed particles 214 including particle core material 218 that is dispersed within the matrix. Nanomatrix 216 is characterized by a solid-state bond layer 219 which extends throughout the nanomatrix. The time in contact with the fluid described above may include the CST as described above. The CST may include a predetermined time that is desired or required to dissolve a predetermined portion of the powder compact 200 that is in contact with the fluid. The CST may also include a time corresponding to a change in the property of the engineered material or the fluid, or a combination thereof. In the case of a change of property of the engineered material, the change may include a change of a temperature of the engineered material. In the case where there is a change in the property of the fluid, the change may include the change in a fluid temperature, pressure, flow rate, chemical composition or pH or a combination thereof. Both the engineered material and the change in the property of the engineered material or the fluid, or a combination thereof, may be tailored to provide the desired CST response characteristic, including the rate of change of the particular property (e.g., weight loss, loss of strength) both prior to the CST (e.g., Stage 1) and after the CST (e.g., Stage 2), as illustrated in FIG. 22.

Referring to FIG. 17, a method 400 of making a powder compact 200. Method 400 includes forming 410 a coated metallic powder 10 comprising powder particles 12 having particle cores 14 with nanoscale metallic coating layers 16 disposed thereon, wherein the metallic coating layers 16 have a chemical composition and the particle cores 14 have a chemical composition that is different than the chemical composition of the metallic coating material 16. Method 400 also includes forming 420 a powder compact by applying a predetermined temperature and a predetermined pressure to the coated powder particles sufficient to sinter them by solid-phase sintering of the coated layers of the plurality of the coated particle powders 12 to form a substantially-continuous, cellular nanomatrix 216 of a nanomatrix material 220 and a plurality of dispersed particles 214 dispersed within nanomatrix 216 as described herein.

Forming 410 of coated metallic powder 10 comprising powder particles 12 having particle cores 14 with nanoscale metallic coating layers 16 disposed thereon may be performed by any suitable method. In an exemplary embodiment, forming 410 includes applying the metallic coating layers 16, as described herein, to the particle cores 14, as described herein, using fluidized bed chemical vapor deposition (FBCVD) as described herein. Applying the metallic coating layers 16 may include applying single-layer metallic coating layers 16 or multilayer metallic coating layers 16 as described herein. Applying the metallic coating layers 16 may also include controlling the thickness of the individual layers as they are being applied, as well as controlling the overall thickness of metallic coating layers 16. Particle cores 14 may be formed as described herein.

Forming 420 of the powder compact 200 may include any suitable method of forming a fully-dense compact of powder 10. In an exemplary embodiment, forming 420 includes dynamic forging of a green-density precursor powder compact 100 to apply a predetermined temperature and a predetermined pressure sufficient to sinter and deform the powder particles and form a fully-dense nanomatrix 216 and dispersed particles 214 as described herein. Dynamic forging as used herein means dynamic application of a load at temperature and for a time sufficient to promote sintering of the metallic coating layers 16 of adjacent powder particles12, and may preferably include application of a dynamic forging load at a predetermined loading rate for a time and at a temperature sufficient to form a sintered and fully-dense powder compact 200. In an exemplary embodiment, dynamic forging included: 1) heating a precursor or green-state powder compact 100 to a predetermined solid phase sintering temperature, such as, for example, a temperature sufficient to promote interdiffusion between metallic coating layers 16 of adjacent powder particles 12; 2) holding the precursor powder compact 100 at the sintering temperature for a predetermined hold time, such as, for example, a time sufficient to ensure substantial uniformity of the sintering temperature throughout the precursor compact 100; 3) forging the precursor powder compact 100 to full density, such as, for example, by applying a predetermined forging pressure according to a predetermined pressure schedule or ramp rate sufficient to rapidly achieve full density while holding the compact at the predetermined sintering temperature; and 4) cooling the compact to room temperature. The predetermined pressure and predetermined temperature applied during forming 420 will include a sintering temperature, T_{S}, and forging pressure, P_{F}, as described herein that will ensure solid-state sintering and deformation of the powder particles 12 to form fully-dense powder compact 200, including solid-state bond 217 and bond layer 219. The steps of heating to and holding the precursor powder compact 100 at the predetermined sintering temperature for the predetermined time may include any suitable combination of temperature and time, and will depend, for example, on the powder 10 selected, including the materials used for particle core 14 and metallic coating layer 16, the size of the precursor powder compact 100, the heating method used and other factors that influence the time needed to achieve the desired temperature and temperature uniformity within precursor powder compact 100. In the step of forging, the predetermined pressure may include any suitable pressure and pressure application schedule or pressure ramp rate sufficient to achieve a fully-dense powder compact 200, and will depend, for example, on the material properties of the powder particles 12 selected, including temperature dependent stress/strain characteristics (e.g., stress/strain rate characteristics), interdiffusion and metallurgical thermodynamic and phase equilibria characteristics, dislocation dynamics and other material properties. For example, the maximum forging pressure of dynamic forging and the forging schedule (i.e., the pressure ramp rates that correspond to strain rates employed) may be used to tailor the mechanical strength and toughness of the powder compact. The maximum forging pressure and forging ramp rate (i.e., strain rate) is the pressure just below the compact cracking pressure, i.e., where dynamic recovery processes are unable to relieve strain energy in the compact microstructure without the formation of a crack in the compact. For example, for applications that require a powder compact that has relatively higher strength and lower toughness, relatively higher forging pressures and ramp rates may be used. If relatively higher toughness of the powder compact is needed, relatively lower forging pressures and ramp rates may be used.

For certain exemplary embodiments of powders 10 described herein and precursor compacts 100 of a size sufficient to form many wellbore tools and components, predetermined hold times of about 1 to about 5 hours may be used. The predetermined sintering temperature, T_{S}, will preferably be selected as described herein to avoid melting of either particle cores 14 and metallic coating layers 16 as they are transformed during method 400 to provide dispersed particles 214 and nanomatrix 216. For these embodiments, dynamic forging may include application of a forging pressure, such as by dynamic pressing to a maximum of about 80 ksi at pressure ramp rate of about 0.5 to about 2 ksi/second.

In an exemplary embodiment where particle cores 14 included Mg and metallic coating layer 16 included various single and multilayer coating layers as described herein, such as various single and multilayer coatings comprising Al, the dynamic forging was performed by sintering at a temperature, T_{S}, of about 450°C to about 470 °C for up to about 1 hour without the application of a forging pressure, followed by dynamic forging by application of isostatic pressures at ramp rates between about 0.5 to about 2 ksi/second to a maximum pressure, P_{S}, of about 30 ksi to about 60 ksi, which resulted in forging cycles of 15 seconds to about 120 seconds. The short duration of the forging cycle is a significant advantage as it limits interdiffusion, including interdiffusion within a given metallic coating layer 16, interdiffusion between adjacent metallic coating layers 16 and interdiffusion between metallic coating layers 16 and particle cores 14, to that needed to form metallurgical bond 217 and bond layer 219, while also maintaining the desirable equiaxed dispersed particle 214 shape with the integrity of cellular nanomatrix 216 strengthening phase. The duration of the dynamic forging cycle is much shorter than the forming cycles and sintering times required for conventional powder compact forming processes, such as hot isostatic pressing (HIP), pressure assisted sintering or diffusion sintering.

Method 400 may also optionally include forming 430 a precursor powder compact by compacting the plurality of coated powder particles 12 sufficiently to deform the particles and form interparticle bonds to one another and form the precursor powder compact 100 prior to forming 420 the powder compact. Compacting may include pressing, such as isostatic pressing, of the plurality of powder particles 12 at room temperature to form precursor powder compact 100. Compacting 430 may be performed at room temperature. In an exemplary embodiment, powder 10 may include particle cores 14 comprising Mg and forming 430 the precursor powder compact may be performed at room temperature at an isostatic pressure of about 10 ksi to about 60 ksi.

Method 400 may optionally also include intermixing 440 a second powder 30 into powder 10 as described herein prior to the forming 420 the powder compact, or forming 430 the precursor powder compact.

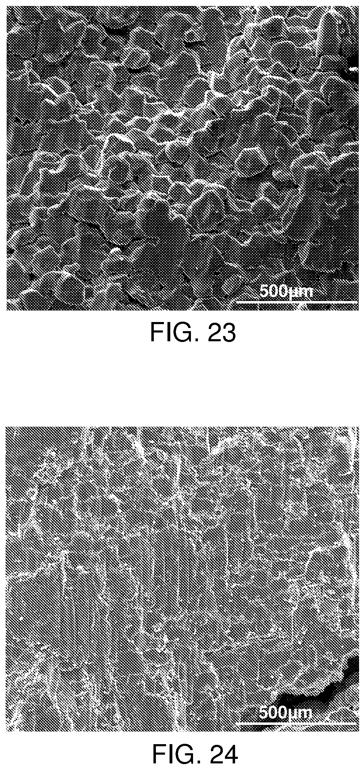

Without being limited by theory, powder compacts 200 are formed from coated powder particles 12 that include a particle core 14 and associated core material 18 as well as a metallic coating layer 16 and an associated metallic coating material 20 to form a substantially-continuous, three-dimensional, cellular nanomatrix 216 that includes a nanomatrix material 220 formed by sintering and the associated diffusion bonding of the respective coating layers 16 that includes a plurality of dispersed particles 214 of the particle core materials 218. This unique structure may include metastable combinations of materials that would be very difficult or impossible to form by solidification from a melt having the same relative amounts of the constituent materials. The coating layers and associated coating materials may be selected to provide selectable and controllable dissolution in a predetermined fluid environment, such as a wellbore environment, where the predetermined fluid may be a commonly used wellbore fluid that is either injected into the wellbore or extracted from the wellbore. As will be further understood from the description herein, controlled dissolution of the nanomatrix exposes the dispersed particles of the core materials. The particle core materials may also be selected to also provide selectable and controllable dissolution in the wellbore fluid. Alternately, they may also be selected to provide a particular mechanical property, such as compressive strength or sheer strength, to the powder compact 200, without necessarily providing selectable and controlled dissolution of the core materials themselves, since selectable and controlled dissolution of the nanomatrix material surrounding these particles will necessarily release them so that they are carried away by the wellbore fluid. The microstructural morphology of the substantially-continuous, cellular nanomatrix 216, which may be selected to provide a strengthening phase material, with dispersed particles 214, which may be selected to provide equiaxed dispersed particles 214, provides these powder compacts with enhanced mechanical properties, including compressive strength and sheer strength, since the resulting morphology of the nanomatrix/dispersed particles can be manipulated to provide strengthening through the processes that are akin to traditional strengthening mechanisms, such as grain size reduction, solution hardening through the use of impurity atoms, precipitation or age hardening and strength/work hardening mechanisms. The nanomatrix/dispersed particle structure tends to limit dislocation movement by virtue of the numerous particle nanomatrix interfaces, as well as interfaces between discrete layers within the nanomatrix material as described herein. This is exemplified in the fracture behavior of these materials, as illustrated in FIGS. 23 and 24. In FIG. 23, a powder compact 200 made using uncoated pure Mg powder and subjected to a shear stress sufficient to induce failure demonstrated intergranular fracture. In contrast, in FIG. 24, a powder compact 200 made using powder particles 12 having pure Mg powder particle cores 14 to form dispersed particles 214 and metallic coating layers 16 that includes Al to form nanomatrix 216 and subjected to a shear stress sufficient to induce failure demonstrated transgranular fracture and a substantially higher fracture stress as described herein. Because these materials have high-strength characteristics, the core material and coating material may be selected to utilize low density materials or other low density materials, such as low-density metals, ceramics, glasses or carbon, that otherwise would not provide the necessary strength characteristics for use in the desired applications, including wellbore tools and components.

While one or more embodiments have been shown and described, modifications and substitutions may be made thereto without departing from the scope of the invention. Accordingly, it is to be understood that the present invention has been described by way of illustrations and not limitation.

## Claims

1. A metallic powder comprising a plurality of metallic powder particles (12), each powder particle (12) comprising:
a particle core (14), the particle core (14) comprises a core material, wherein the core material is pure Mg, pure Al, pure Zn or pure Mn, or the core material comprises Mg-Zn, Mg-Al, Mg-Mn, or Mg-Zn-Y, or the core material comprises an Mg-Al-X alloy, wherein X is Zn, Mn, Si, Ca or Y, or a combination thereof, wherein the core material has a melting temperature (T_{P}); and
at least one metallic coating layer (16) disposed on the particle core (14) and comprising a metallic coating material having a melting temperature (T_{C}), wherein the powder particles (12) are configured for solid-state sintering to one another at a predetermined sintering temperature (T_{S}), and T_{S} is less than T_{P} and T_{C} to form a powder metal compact (200) by joining the at least one metallic coating layers (16) by solid-state bonding to form a solid state layer extending throughout a cellular nanomatrix (216) of the metallic coating material between dispersed particles (214) of the core material;
wherein the metallic coating layer (16) comprises a plurality of coating layers (16,24);
wherein the plurality of coating layers (16,24) comprises a first coating layer (16) that is disposed on the particle core (12) and a second coating layer (24) that is disposed on the first layer (16); and
wherein the first layer (16) comprises Al or Ni, or a combination thereof, and the second layer (24) comprises Al, Zn, Mn, Mg, Mo, W, Cu, Fe, Ca, Co, Ta, Re or Ni, or a combination thereof, wherein the first coating layer (16) has a chemical composition that is different than a chemical composition of the second coating layer (24).

2. The metal powder of claim 1, wherein the Mg-Al-X alloy comprises, by weight, up to 85% Mg, up to 15% Al and up to 5% X.

3. The metal powder of claim 1, wherein the core material further comprises a rare earth element.

4. The metal powder of claim 3, wherein the rare earth element comprises, by weight, less than 5% of the particle core (14).

5. The metal powder of claim 1, wherein the metallic coating layer (16) has a thickness of 25nm to 2500nm.

6. The metal powder of claim 1, further comprising a third coating layer (26) that is disposed on the second coating layer (24).

7. The metal powder of claim 6, wherein the third coating layer comprises Al, Zn, Mn, Mg, Mo, W, Cu, Fe, Ca, Co, Ta, Re or Ni, or a combination thereof, wherein the first coating layer has a chemical composition that is different than a chemical composition of the second coating layer, and the chemical composition of the second coating layer is different than a chemical composition of the third layer.

8. The metal powder of claim 6, further comprising a fourth coating layer (28) that is disposed on the third coating layer (26).

9. The metal powder of claim 8, wherein the third coating layer (26) comprises Al, Zn, Mn, Mg, Mo, W, Cu, Fe, Ca, Co, Ta, Re or Ni, or a combination of any of the aforementioned third coating layer materials, and the fourth coating layer (28) comprises Al, Mn, Fe, Co or Ni, or a combination thereof, wherein the first coating layer (16) has a chemical composition that is different than a chemical composition of the second coating layer (24), and the chemical composition of the second coating layer (24) is different than a chemical composition of the third coating layer (26), and the chemical composition of the third coating layer (28) is different than a chemical composition of the fourth coating layer (28).

10. A method of making a metal powder, comprising:
forming a metal powder comprising a plurality of powder particles (12), wherein the plurality of the powder particles comprise pure Mg, pure Al, pure Zn or pure Mn, or the plurality of powder particles comprises Mg-Zn, Mg-Al, Mg-Mn, or Mg-Zn-Y, or the plurality of powder particles comprises an Mg-Al-X alloy, wherein X is Zn, Mn, Si, Ca or Y, or a combination thereof, wherein the plurality of powder particles (12) have a melting temperature (T_{P}), for use as a plurality of particle cores (14); and
depositing at least one metallic coating layer (16) on each of the plurality of particle cores (14), the metallic coating layer (16) having a melting temperature (T_{C}), wherein the powder particles (12) are configured for solid-state sintering to one another at a predetermined sintering temperature (T_{S}), and T_{S} is less than T_{P} and T_{C} to form a powder metal compact (200) by joining the at least one metallic coating layers (16) by solid-state bonding to form a solid state layer extending throughout a cellular nanomatrix (216) of the metallic coating material between dispersed particles (214) of the core material;
wherein depositing the metallic coating layer (16) comprises depositing a plurality of coating layers (16,24); and
depositing the metallic coating layer (16) comprises depositing a first coating layer (16) comprising Al or Ni, or a combination thereof, on the particle core (14); and
depositing the coating layer (16) further comprises depositing a second layer (24) comprising Al, Zn, Mn, W, Cu, Fe, Co or Ni, or a combination thereof, on the first layer (16), wherein the first layer (16) has a chemical composition that is different than a chemical composition of the second layer (24).

11. The method of claim 10, wherein forming the metal powder (12) comprises vacuum spray forming or inert gas spray forming.

12. The method of claim 10, wherein depositing the coating layer (16) comprises depositing the coating material by fluidized bed chemical vapor deposition.

13. The method of claim 10, wherein adjacent coating layers (16;24) have different chemical compositions.

14. The method of claim 10, wherein depositing the coating layer (16) further comprises depositing a third layer (26) comprising Al, Mn, Fe, Co or Ni, or a combination thereof, on the second layer (24), wherein the first layer (16) has a chemical composition that is different than a chemical composition of the second layer (24), and the chemical composition of the second layer (24) is different than a chemical composition of the third layer (26).

15. The method of claim 10, wherein depositing the coating layer (16) further comprises depositing: a third layer (26) comprising Al, Zn, Mn, W, Cu, Fe, Co or Ni, or an oxide, nitride or carbide thereof, or a combination of any of the aforementioned third layer materials, on the second layer (24); and a fourth layer (28) comprising Al, Mn, Fe, Co or Ni, or a combination thereof, on the third layer (26), wherein the first layer (16) has a chemical composition that is different than a chemical composition of the second layer (24), and the chemical composition of the second layer (24) is different than a chemical composition of the third layer (26), and the chemical composition of the third layer (26) is different than a chemical composition of the fourth layer (28).

## Patentansprüche

1. Metallisches Pulver, umfassend eine Vielzahl von metallischen Pulverteilchen (12), wobei jedes Pulverteilchen (12) Folgendes umfasst:
einen Teilchenkern (14), wobei der Teilchenkern (14) ein Kernmaterial umfasst, wobei das Kernmaterial reines Mg, reines AI, reines Zn oder reines Mn ist, oder das Kernmaterial Mg-Zn, Mg-Al, Mg-Mn oder Mg-Zn-Y umfasst, oder das Kernmaterial eine Mg-Al-X-Legierung umfasst, wobei X Zn, Mn, Si, Ca oder Y oder eine Kombination davon ist, wobei das Kernmaterial eine Schmelztemperatur (T_{P}) aufweist; und
mindestens eine metallische Schicht (16), die auf dem Teilchenkern (14) angeordnet ist und ein metallisches Beschichtungsmaterial mit einer Schmelztemperatur (T_{C}) umfasst, wobei die Pulverteilchen (12) zum Festphasensintern aneinander bei einer vorgegebenen Sintertemperatur (T_{S}) konfiguriert sind und T_{S} kleiner als T_{P} und T_{C} ist, um einen Pulvermetallpresskörper (200) zu bilden, indem die mindestens eine metallische Beschichtungslagen (16) durch Festphasenverbinden verbunden werden, um eine Festphasenlage zu bilden, die sich durch eine gesamte zellulare Nanomatrix (216) des metallischen Beschichtungsmaterials zwischen dispergierten Teilchen (214) des Kernmaterials erstreckt;
wobei die metallische Beschichtungslage (16) eine Vielzahl von Beschichtungslagen (16, 24) umfasst;
wobei die Vielzahl von Beschichtungslagen (16, 24) eine auf dem Teilchenkern (12) angeordnete erste Beschichtungslage (16) und eine auf der ersten Lage (16) angeordnete zweite Beschichtungslage (24) umfasst; und
wobei die erste Lage (16) AI oder Ni oder eine Kombination davon umfasst, und die zweite Schicht (24) AI, Zn, Mn, Mg, Mo, W, Cu, Fe, Ca, Co, Ta, Re oder Ni oder eine Kombination davon umfasst, wobei die erste Beschichtungslage (16) eine chemische Zusammensetzung aufweist, die sich von einer chemischen Zusammensetzung der zweiten Beschichtungslage (24) unterscheidet.

2. Metallpulver nach Anspruch 1, wobei die Mg-Al-X-Legierung bis zu 85 Gew.-% Mg, bis zu 15 Gew.-% AI und bis zu 5 Gew.-% X umfasst.

3. Metallpulver nach Anspruch 1, wobei das Kernmaterial ferner ein Seltenerdelement umfasst.

4. Metallpulver nach Anspruch 3, wobei das Seltenerdelement weniger als 5 Gew.-% des Teilchenkerns (14) umfasst.

5. Metallpulver nach Anspruch 1, wobei die metallische Beschichtungslage (16) eine Dicke von 25 nm bis 2500 nm aufweist.

6. Metallpulver nach Anspruch 1, ferner umfassend eine dritte Beschichtungslage (26), die auf der zweiten Beschichtungslage (24) angeordnet ist.

7. Metallpulver nach Anspruch 6, wobei die dritte Beschichtungslage AI, Zn, Mn, Mg, Mo, W, Cu, Fe, Ca, Co, Ta, Re oder Ni oder eine Kombination davon umfasst, wobei die erste Beschichtungslage eine chemische Zusammensetzung aufweist, die sich von einer chemischen Zusammensetzung der zweiten Beschichtungslage unterscheidet, und sich die chemische Zusammensetzung der zweiten Beschichtungslage von der chemischen Zusammensetzung der dritten Lage unterscheidet.

8. Metallpulver nach Anspruch 6, ferner umfassend eine vierte Beschichtungslage (28), die auf der dritten Beschichtungslage (26) angeordnet ist.

9. Metallpulver nach Anspruch 8, wobei die dritte Beschichtungslage (26) AI, Zn, Mn, Mg, Mo, W, Cu, Fe, Ca, Co, Ta, Re oder Ni oder eine Kombination von beliebigen der genannten Materialien der dritten Beschichtungslage umfasst und die vierte Beschichtungslage (28) AI, Mn, Fe, Co oder Ni oder eine Kombination davon umfasst, wobei die erste Beschichtungslage (16) eine chemische Zusammensetzung aufweist, die sich von einer chemischen Zusammensetzung der zweiten Beschichtungslage (24) unterscheidet, und sich die chemische Zusammensetzung der zweiten Beschichtungslage (24) von einer chemischen Zusammensetzung der dritten Beschichtungslage (26) unterscheidet, und sich die chemische Zusammensetzung der dritten Beschichtungslage (28) von der chemischen Zusammensetzung der vierten Beschichtungslage (28) unterscheidet.

10. Verfahren zum Herstellen eines Metallpulvers, umfassend:
Bilden eines Metallpulvers umfassend eine Vielzahl von Pulverteilchen (12), wobei die Vielzahl von Pulverteilchen reines Mg, reines AI, reines Zn oder reines Mn umfasst oder die Vielzahl von Pulverteilchen Mg-Zn, Mg-Al, Mg-Mn oder Mg-Zn-Y umfasst oder die Vielzahl von Pulverteilchen eine Mg-Al-X-Legierung umfasst, wobei X Zn, Mn, Si, Ca oder Y oder eine Kombination davon ist, wobei die Vielzahl von Pulverteilchen (12) eine Schmelztemperatur (T_{P}) aufweist, zur Verwendung als eine Vielzahl von Teilchenkernen (14); und
Abscheiden von mindestens einer metallischen Schicht (16) auf jedem der Vielzahl von Teilchenkernen (14), wobei die metallische Schicht (16) eine Schmelztemperatur (T_{C}) aufweist, wobei die Pulverteilchen (12) zum Festphasensintern aneinander bei einer vorgegebenen Sintertemperatur (T_{S}) konfiguriert sind, und T_{S} kleiner als T_{P} und T_{C} ist, um einen Pulvermetallpresskörper (200) zu bilden, indem die mindestens eine metallische Beschichtungslage (16) durch Festphasenverbinden verbunden wird, um eine Festphasenlage zu bilden, die sich durch eine gesamte zellulare Nanomatrix (216) des metallischen Beschichtungsmaterials zwischen dispergierten Teilchen (214) des Kernmaterials erstreckt;
wobei das Abscheiden der metallischen Beschichtungslage (16) das Abscheiden einer Vielzahl von Beschichtungslagen (16, 24) umfasst; und
das Abscheiden der metallischen Beschichtungslage (16) das Abscheiden einer ersten Beschichtungslage (16), die AI oder Ni oder eine Kombination davon umfasst, auf dem Teilchenkern (14) umfasst; und
das Abscheiden der Beschichtungslage (16) ferner das Abscheiden einer zweiten Lage (24), die AI, Zn, Mn, W, Cu, Fe, Co oder Ni oder eine Kombination davon, auf der ersten Lage (16) umfasst, wobei die erste Beschichtungslage (16) eine chemische Zusammensetzung aufweist, die sich von einer chemischen Zusammensetzung der zweiten Beschichtungslage (24) unterscheidet.

11. Verfahren nach Anspruch 10, wobei das Bilden des Metallpulvers (12) Vakuumspritzformen oder Inertgasspritzformen umfasst.

12. Verfahren nach Anspruch 10, wobei das Abscheiden der Beschichtungslage (16) das Abscheiden des Beschichtungsmaterials durch chemische Gasphasenabscheidung mittels Wirbelschicht umfasst.

13. Verfahren nach Anspruch 10, wobei benachbarte Beschichtungslagen (16; 24) unterschiedliche chemische Zusammensetzungen aufweisen.

14. Verfahren nach Anspruch 10, wobei das Abscheiden der Beschichtungslage (16) ferner das Abscheiden einer dritten Lage (26), die AI, Mn, Fe, Co oder Ni oder eine Kombination davon umfasst, auf der zweiten Lage (24) umfasst, wobei die erste Lage (16) eine chemische Zusammensetzung aufweist, die sich von einer chemischen Zusammensetzung der zweiten Lage (24) unterscheidet, und sich die chemische Zusammensetzung der zweiten Lage (24) von der chemischen Zusammensetzung der dritten Lage (26) unterscheidet.

15. Verfahren nach Anspruch 10, wobei das Abscheiden der Beschichtungslage (16) ferner das Abscheiden von: einer dritten Lage (26), die Al, Zn, Mn, W, Cu, Fe, Co oder Ni oder ein Oxid, Nitrid oder Carbid davon oder eine Kombination aus beliebigen genannten Materialien der dritten Lage auf der zweiten Lage (24); und einer vierten Lage (28), die AI, Mn, Fe, Co oder Ni oder eine Kombination davon umfasst, auf der dritten Lage (26) umfasst, wobei die erste Lage (16) eine chemische Zusammensetzung aufweist, die sich von einer chemischen Zusammensetzung der zweiten Lage (24) unterscheidet, und sich die chemische Zusammensetzung der zweiten Lage (24) von einer chemischen Zusammensetzung der dritten Lage (26) unterscheidet, und sich die chemische Zusammensetzung der dritten Lage (26) von der chemischen Zusammensetzung der vierten Lage (28) unterscheidet.

## Revendications

1. Poudre métallique comprenant une pluralité de particules de poudre métallique (12), chaque particule de poudre (12) comprenant :
un noyau de particule (14), le noyau de particule (14) comprenant un matériau de noyau, le matériau de noyau étant du Mg pur, de l'Al pur, du Zn pur ou du Mn pur, ou le matériau de noyau comprenant Mg-Zn, Mg-AI, Mg-Mn ou Mg-Zn-Y, ou le matériau de noyau comprenant un alliage de Mg-Al-X, X étant Zn, Mn, Si, Ca ou Y, ou une combinaison de ceux-ci, le matériau de noyau possédant une température de fusion (T_{P}) ; et
au moins une couche de revêtement métallique (16) disposée sur le noyau de particule (14) et comprenant un matériau de revêtement métallique possédant une température de fusion (T_{C}), les particules de poudre (12) étant conçues pour un frittage les unes aux autres à l'état solide à une température de frittage prédéterminée (T_{S}) et T_{S} étant inférieur à T_{P} et à T_{C}, afin de former un compact de poudre métallique (200) par assemblage de ladite au moins une couche de revêtement métallique (16) par liaison à l'état solide pour former une couche à l'état solide s'étendant à travers une nanomatrice cellulaire (216) du matériau de revêtement métallique entre les particules dispersées (214) du matériau de noyau ;
la couche de revêtement métallique (16) comprenant une pluralité de couches de revêtement (16, 24) ;
la pluralité de couches de revêtement (16, 24) comprenant une première couche de revêtement (16) qui est disposée sur le noyau de particule (12) et une deuxième couche de revêtement (24) qui est disposée sur la première couche (16) ; et
la première couche (16) comprenant Al ou Ni, ou une combinaison de ceux-ci, et la deuxième couche (24) comprenant Al, Zn, Mn, Mg, Mo, W, Cu, Fe, Ca, Co, Ta, Re ou Ni, ou une combinaison de ceux-ci, la première couche de revêtement (16) possédant une composition chimique qui est différente d'une composition chimique de la deuxième couche de revêtement (24).

2. Poudre métallique selon la revendication 1, l'alliage Mg-AI-X comprenant, en poids, jusqu'à 85 % de Mg, jusqu'à 15 % d'AI et jusqu'à 5 % de X.

3. Poudre métallique selon la revendication 1, le matériau de noyau comprenant en outre un élément des terres rares.

4. Poudre métallique selon la revendication 3, l'élément des terres rares comprenant, en poids, moins de 5 % du noyau de particule (14).

5. Poudre métallique selon la revendication 1, la couche de revêtement métallique (16) possédant une épaisseur de 25 nm à 2500 nm.

6. Poudre métallique selon la revendication 1, comprenant en outre une troisième couche de revêtement (26) qui est disposée sur la deuxième couche de revêtement (24).

7. Poudre métallique selon la revendication 6, la troisième couche de revêtement comprenant Al, Zn, Mn, Mg, Mo, W, Cu, Fe, Ca, Co, Ta, Re ou Ni, ou une combinaison de ceux-ci, la première couche de revêtement possédant une composition chimique qui est différente d'une composition chimique de la deuxième couche de revêtement et la composition chimique de la deuxième couche de revêtement étant différente d'une composition chimique de la troisième couche.

8. Poudre métallique selon la revendication 6, comprenant en outre une quatrième couche de revêtement (28) qui est disposée sur la troisième couche de revêtement (26).

9. Poudre métallique selon la revendication 8, la troisième couche de revêtement (26) comprenant Al, Zn, Mn, Mg, Mo, W, Cu, Fe, Ca, Co, Ta, Re ou Ni, ou une combinaison de n'importe lesquels des matériaux susmentionnés de la troisième couche de revêtement, et la quatrième couche de revêtement (28) comprenant Al, Mn, Fe, Co ou Ni, ou une combinaison de ceux-ci, la première couche de revêtement (16) possédant une composition chimique qui est différente d'une composition chimique de la deuxième couche de revêtement (24) et la composition chimique de la deuxième couche de revêtement (24) étant différente d'une composition chimique de la troisième couche de revêtement (26) et la composition chimique de la troisième couche de revêtement (28) étant différente d'une composition chimique de la quatrième couche de revêtement (28).

10. Procédé de fabrication d'une poudre métallique, comprenant :
la formation d'une poudre métallique comprenant une pluralité de particules de poudre (12), la pluralité de particules de poudre comprenant du Mg pur, de l'Al pur, du Zn pur ou du Mn pur, ou la pluralité de particules de poudre comprenant Mg-Zn, Mg-AI, Mg-Mn ou Mg-Zn-Y, ou la pluralité de particules de poudre comprenant un alliage Mg-Al-X, X étant Zn, Mn, Si, Ca ou Y, ou une combinaison de ceux-ci, la pluralité de particules de poudre (12) possédant une température de fusion (T_{P}), pour une utilisation en tant que pluralité de noyaux de particule (14) ; et
le dépôt d'au moins une couche de revêtement métallique (16) sur chacun de la pluralité de noyaux de particule (14), la couche de revêtement métallique (16) possédant une température de fusion (T_{C}), les particules de poudre (12) étant conçues pour un frittage les unes aux autres à l'état solide à une température de frittage prédéterminée (T_{S}) et T_{S} étant inférieur à T_{P} et à T_{C}, afin de former un compact de poudre métallique (200) par l'assemblage de ladite au moins une couche de revêtement métallique (16) par liaison à l'état solide pour former une couche à l'état solide s'étendant à travers une nanomatrice cellulaire (216) du matériau de revêtement métallique entre les particules (214) dispersées du matériau de noyau ;
le dépôt de la couche de revêtement métallique (16) comprenant le dépôt d'une pluralité de couches de revêtement (16, 24) ; et
le dépôt de la couche de revêtement métallique (16) comprenant le dépôt d'une première couche de revêtement (16) comprenant Al ou Ni, ou une combinaison de ceux-ci, sur le noyau de particule (14) ; et
le dépôt de la couche de revêtement (16) comprenant en outre le dépôt d'une deuxième couche (24) comprenant Al, Zn, Mn, W, Cu, Fe, Co ou Ni, ou une combinaison de ceux-ci, sur la première couche (16), la première couche (16) possédant une composition chimique qui est différente d'une composition chimique de la deuxième couche (24).

11. Procédé selon la revendication 10, la formation de la poudre métallique (12) comprenant la formation par pulvérisation sous vide ou la formation par pulvérisation sous gaz inerte.

12. Procédé selon la revendication 10, le dépôt de la couche de revêtement (16) comprenant le dépôt du matériau de revêtement par dépôt chimique en phase vapeur en lit fluidisé.

13. Procédé selon la revendication 10, des couches de revêtement (16 ; 24) adjacentes possédant des compositions chimiques différentes.

14. Procédé selon la revendication 10, le dépôt de la couche de revêtement (16) comprenant en outre le dépôt ; d'une troisième couche (26) comprenant Al, Mn, Fe, Co ou Ni, ou une combinaison de ceux-ci, sur la deuxième couche (24), la première couche (16) possédant une composition chimique qui est différente d'une composition chimique de la deuxième couche (24) et la composition chimique de la deuxième couche (24) étant différente d'une composition chimique de la troisième couche (26).

15. Procédé selon la revendication 10, le dépôt de la couche de revêtement (16) comprenant en outre le dépôt d'une troisième couche (26) comprenant Al, Zn, Mn, W, Cu, Fe, Co ou Ni, ou un oxyde, un nitrure ou un carbure de ceux-ci, ou une combinaison de n'importe lesquels des matériaux susmentionnés de la troisième couche, sur la deuxième couche (24) ; et d'une quatrième couche (28) comprenant Al, Mn, Fe, Co ou Ni, ou d'une combinaison de ceux-ci, sur la troisième couche (26), la première couche (16) possédant un composition chimique qui est différente d'une composition chimique de la deuxième couche (24) et la composition chimique de la deuxième couche (24) étant différente d'une composition chimique de la troisième couche (26) et la composition chimique de la troisième couche (26) étant différente d'une composition chimique de la quatrième couche (28).
